(19) Europäisches Patentamt
European Patent Office
Office européen des brevets

(11) **EP 4 421 792 A1**

(12) **EUROPEAN PATENT APPLICATION**
published in accordance with Art. 153(4) EPC

(43) Date of publication:
**28.08.2024 Bulletin 2024/35**

(21) Application number: **22955293.0**

(22) Date of filing: **17.08.2022**

(51) International Patent Classification (IPC):
**G09G 3/3233** (2016.01)

(52) Cooperative Patent Classification (CPC):
G09G 3/3233; G09G 2300/0426; G09G 2320/0223

(86) International application number:
**PCT/CN2022/113060**

(87) International publication number:
**WO 2024/036511 (22.02.2024 Gazette 2024/08)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **BOE Technology Group Co., Ltd.
Chaoyang District,
Beijing 100015 (CN)**

(72) Inventors:
• **WEN, Mengyang
Beijing 100176 (CN)**

• **ZHU, Jianchao
Beijing 100176 (CN)**
• **LIU, Hao
Beijing 100176 (CN)**
• **SHANG, Guangliang
Beijing 100176 (CN)**
• **HAN, Xinbin
Beijing 100176 (CN)**
• **ZHANG, Yuxin
Beijing 100176 (CN)**
• **LIU, Libin
Beijing 100176 (CN)**

(74) Representative: **Durán-Corretjer, S.L.P.
Còrsega, 329
(Paseo de Gracia/Diagonal)
08037 Barcelona (ES)**

(54) **DISPLAY SUBSTRATE AND DISPLAY DEVICE**

(57)     A display substrate is disclosed, including a base substrate (100), a plurality of data lines (DL), a plurality of sub-pixels (Px), a plurality of data lead-out lines, and at least one first compensation unit (41). The base substrate (100) includes a display area (AA) and a first bezel area (B1) located on a side of the display area (AA). The plurality of data lines (DL) and the plurality of sub-pixels (Px) are located in the display area (AA). The plurality of data lead-out lines are located in the first bezel area (B1) and electrically connected with the plurality of data lines (DL) in the display area (AA). The at least one first compensation unit (41) is located in the first bezel area (B1). At least one data lead-out line is electrically connected with the at least one first compensation unit (41), and the at least one first compensation unit (41) is configured to compensate at least one of resistance and capacitance of a data line (DL) electrically connected with the at least one data lead-out line.

FIG. 24

EP 4 421 792 A1

**Description**

Technical Field

The present disclosure relates to, but is not limited to, the field of display technology, in particular to a display substrate and a display device.

Background

An Organic Light Emitting Diode (OLED) and a Quantum dot Light Emitting Diode (QLED) are active light emitting display devices and have advantages of self-luminescence, wide viewing angle, high contrast ratio, low power consumption, very high response speed, lightness and thinness, bendability, and low cost, etc.

Summary

The following is a summary of subject matter described herein in detail. The summary is not intended to limit the scope of protection of the claims.

Embodiments of the present disclosure provide a display substrate and a display device.

In one aspect, an embodiment of the present disclosure provides a display substrate, including a base substrate, a plurality of data lines, a plurality of sub-pixels, a plurality of data lead-out lines, and at least one first compensation unit. The base substrate includes a display area and a first bezel area located on a side of the display area. The plurality of data lines and the plurality of sub-pixels are located in the display area. The plurality of sub-pixels are electrically connected with the plurality of data lines. The plurality of data lead-out lines are located in the first bezel area and electrically connected with the plurality of data lines in the display area. At least one first compensation unit is located in the first bezel area. At least one data lead-out line in the plurality of data lead-out lines is electrically connected with the at least one first compensation unit. The at least one first compensation unit is configured to compensate at least one of resistance and capacitance of a data line with which at least one data lead-out line is electrically connected.

In some exemplary implementation modes, each first compensation unit includes at least one of the following: at least one first compensation resistor and at least one first compensation capacitor, the at least one first compensation resistor is configured to compensate the resistance of the data line electrically connected with the at least one data lead-out line, and the at least one first compensation capacitor is configured to compensate the capacitance of the data line electrically connected with the at least one data lead-out line.

In some exemplary implementation modes, the first compensation unit includes at least one first compensation resistor, and the at least one first compensation resistor is electrically connected in series with the data lead-out lines.

In some exemplary implementation modes, each first compensation resistor includes a resistor trace, and the resistor trace is located in a first gate metal layer or a second gate metal layer, and the first gate metal layer and the second gate metal layer are located in different layers.

In some exemplary implementation modes, an orthographic projection of the resistor trace of the first compensation resistor on the base substrate is a serpentine trace.

In some exemplary implementation modes, the first compensation unit further includes: at least one first compensation capacitor, the at least one first compensation capacitor includes a first electrode and a second electrode, the first electrode of the at least one first compensation capacitor is electrically connected with the at least one first compensation resistor, and the second electrode of the at least one first compensation capacitor is electrically connected with a ground terminal.

In some exemplary implementation modes, the at least one first compensation capacitor includes: a first electrode plate, a second electrode plate, and a third electrode plate arranged in sequence in a direction away from the base substrate, orthographic projections of the first electrode plate, the second electrode plate, and the third electrode plate on the base substrate are overlapped; the first electrode plate and the third electrode plate are electrically connected with each other to form the first electrode, and the second electrode plate serves as the second electrode.

In some exemplary implementation modes, the second electrode plate of the at least one first compensation capacitor is of an integral structure.

In some exemplary implementation modes, the first electrode plate is located in a first gate metal layer, the second electrode plate is located in a second gate metal layer, and the third electrode plate is located in a third gate metal layer; the first gate metal layer, the second gate metal layer, and the third gate metal layer are located in different layers.

In some exemplary implementation modes, the first bezel area includes a first fan-out region located on one side of the display area, and the first fan-out region is provided with at least one dam spacer. At least one data lead-out line of the plurality of data lead-out lines includes: a first data fan-out line and a second data fan-out line which are located in the first fan-out region and electrically connected with each other, wherein the second data fan-out line is located on a side of the first data fan-out line away from the display area; the second data fan-out line is located on a side of the first data fan-out line close to the base substrate. A connection position of the first data fan-out line and the second data fan-out line is located on a side of the dam spacer close to the display area, and an orthographic projection of the connection position on the base substrate is not overlapped with an orthographic projection of the dam spacer on the base substrate.

In some exemplary implementation modes, a resistivity of a material of the first data fan-out line is less than a resistivity of a material of the second data fan-out line.

In some exemplary implementation modes, the first fan-out region includes a plurality of first data fan-out lines and a plurality of second data fan-out lines. The plurality of first data fan-out lines include a plurality of first type first data fan-out lines and a plurality of second type first data fan-out lines, wherein the first type first data fan-out lines and the second type first data fan-out lines are arranged at intervals, a first type first data fan-out line is located on a side of a second type first data fan-out line close to the base substrate, and an orthographic projection of the first type first data fan-out line on the base substrate is not overlapped with an orthographic projection of the second type first data fan-out line on the base substrate. The plurality of second data fan-out lines include a plurality of first type second data fan-out lines and a plurality of second type second data fan-out lines, the first type second data fan-out lines and the second type second data fan-out lines are arranged at intervals, a first type second data fan-out line is located on a side of a second type second data fan-out line close to the base substrate, and an orthographic projection of the first type second data fan-out line on the base substrate is not overlapped with an orthographic projection of the second type second data fan-out line on the base substrate.

In some exemplary implementation modes, the first type first data fan-out line is electrically connected with the first type second data fan-out line, and the second type first data fan-out line and the second type second data fan-out line are electrically connected.

In some exemplary implementation modes, the first type first data fan-out line is located in a first source-drain metal layer, and the second type first data fan-out line is located in a second source-drain metal layer; the first type second data fan-out line is located in a first gate metal layer, and the second type second data fan-out line is located in a second gate metal layer. The first gate metal layer, the second gate metal layer, the first source-drain metal layer, and the second source-drain metal layer are located in different layers.

In some exemplary implementation modes, the first compensation unit is electrically connected with the first data fan-out line, and the first compensation unit is located in the first fan-out region and on a side of the first data fan-out line close to the display area.

In some exemplary implementation modes, the first bezel area further includes a bending region and a second fan-out region that are sequentially disposed along a direction of the first fan-out region away from the display area. The at least one data lead-out line includes: a data bending line located in the bending region and a third data fan-out line located in the second fan-out region; the data bending line is electrically connected with the second data fan-out line of the first fan-out region and a third data fan-out line of the second fan-out region.

In some exemplary implementation modes, the first data fan-out line and the third data fan-out line that are electrically connected with the second data fan-out line are disposed in a same layer.

In some exemplary implementation modes, the base substrate further includes a second bezel area located on remaining sides of the display area; the second bezel area is provided with at least one second compensation unit and at least one first signal line; the at least one first signal line is electrically connected with the at least one second compensation unit, and the at least one second compensation unit is configured to compensate at least one of resistance and capacitance of the at least one first signal line.

In some exemplary implementation modes, each second compensation unit includes at least one second compensation capacitor, a first electrode of the at least one second compensation capacitor is electrically connected with the at least one first signal line, and a second electrode of the at least one second compensation capacitor is electrically connected with a ground terminal.

In some exemplary implementation modes, the base substrate further includes a second bezel area located on remaining sides of the display area. The second bezel area is provided with a gate drive circuit and a clock signal line electrically connected with the gate drive circuit. The first bezel area is further provided with a third compensation unit, the clock signal line is electrically connected with the third compensation unit, and the third compensation unit is configured to compensate at least one of resistance and capacitance of the clock signal line.

In another aspect, an embodiment of the present disclosure provides a display device, which includes the aforementioned display substrate.

After the drawings and the detailed descriptions are read and understood, the other aspects may be comprehended.

Brief Description of Drawings

Accompanying drawings are used for providing further understanding of technical solutions of the present disclosure, constitute a part of the specification, and are used for explaining the technical solutions of the present disclosure together with embodiments of the present disclosure, but do not constitute limitations on the technical solutions of the present disclosure. Shapes and sizes of one or more components in the drawings do not reflect actual scales, and are only intended to schematically describe contents of the present disclosure.

FIG. 1 is a schematic diagram of a display substrate according to at least one embodiment of the present disclosure.

FIG. 2 is an equivalent circuit diagram of a pixel circuit according to at least one embodiment of the present disclosure.

FIG. 3 is an operating timing diagram of the pixel circuit shown in FIG. 2.

FIG. 4 is a schematic partial plan view of a display area according to at least one embodiment of the present disclosure.

FIG. 5 is a schematic partial cross-sectional view along a Q-Q' direction in FIG. 4.

FIG. 6 is a schematic diagram of a display area after a light shielding layer is formed in FIG. 4.

FIG. 7 is a schematic diagram of a display area after a first semiconductor layer is formed in FIG. 4.

FIG. 8 is a schematic diagram of a display area after a first gate metal layer is formed in FIG. 4.

FIG. 9 is a schematic diagram of a display area after a second gate metal layer is formed in FIG. 4.

FIG. 10 is a schematic diagram of a display area after a second semiconductor layer is formed in FIG. 4.

FIG. 11 is a schematic diagram of a display area after a third gate metal layer is formed in FIG. 4.

FIG. 12 is a schematic diagram of a display area after a sixth insulation layer is formed in FIG. 4.

FIG. 13 is a schematic diagram of a display area after a first source-drain metal layer is formed in FIG. 4.

FIG. 14 is a schematic diagram of a display area after an eighth insulation layer is formed in FIG. 4.

FIG. 15 is a schematic diagram of a display area after a second source-drain metal layer is formed in FIG. 4.

FIG. 16 is a schematic diagram of a second source-drain metal layer in FIG. 15.

FIG. 17 is a schematic diagram of a display area after a ninth insulation layer is formed in FIG. 4.

FIG. 18 is a schematic diagram of a display area after a third source-drain metal layer is formed in FIG. 4.

FIG. 19 is a schematic diagram of a third source-drain metal layer in FIG. 18.

FIG. 20 is a schematic diagram of a display area after a tenth insulation layer is formed in FIG. 4.

FIG. 21 is a schematic diagram of a display area after an anode layer is formed in FIG. 4.

FIG. 22 is a partial trace diagram of a first bezel area according to at least one embodiment of the present disclosure.

FIG. 23 is an equivalent circuit diagram of a first compensation unit according to at least one embodiment of the present disclosure.

FIG. 24 is a partial schematic diagram of a first bezel area according to at least one embodiment of the present disclosure.

FIG. 25 is an equivalent circuit diagram of a first anti-static circuit according to at least one embodiment of the present disclosure.

FIG. 26 is a partial enlarged schematic diagram of a region D1 in FIG. 24.

FIG. 27 is a schematic diagram of a light shielding layer in FIG. 26.

FIG. 28 is a partial schematic diagram of a first bezel area after a first semiconductor layer is formed in FIG. 26.

FIG. 29 is a partial schematic diagram of a first bezel area after a first gate metal layer is formed in FIG. 26.

FIG. 30 is a partial schematic diagram of a first bezel area after a second gate metal layer is formed in FIG. 26.

FIG. 31 is a partial schematic diagram of a first bezel area after a sixth insulation layer is formed in FIG. 26.

FIG. 32 is a partial schematic diagram of a first bezel area after a first source-drain metal layer is formed in FIG. 26.

FIG. 33 is a partial schematic diagram of a first bezel area after an eighth insulation layer is formed in FIG. 26.

FIG. 34 is a partial schematic diagram of a first bezel area after a second source-drain metal layer is formed in FIG. 26.

FIG. 35 is a partial schematic diagram of a first bezel area after a ninth insulation layer is formed in FIG. 26.

FIG. 36 is a partial schematic diagram of a first compensation resistor according to at least one embodiment of the present disclosure.

FIG. 37 is a partial enlarged schematic diagram of a region D2 in FIG. 24.

FIG. 38 is a partial schematic diagram of a first fan-out region after a first gate metal layer is formed in FIG. 37.

FIG. 39 is a partial schematic diagram of a first fan-out region after a second gate metal layer is formed in FIG. 37.

FIG. 40 is a partial schematic diagram of a first fan-out region after a third gate metal layer is formed in FIG. 37.

FIG. 41 is a partial schematic diagram of a first fan-out region after a sixth insulation layer is formed in FIG. 37.

FIG. 42 is a partial enlarged schematic diagram of a region D3 in FIG. 24.

FIG. 43 is a partial schematic diagram of a first fan-out region after a second gate metal layer is formed in FIG. 42.

FIG. 44 is a partial schematic diagram of a first fan-out region after a first source-drain metal layer is formed in FIG. 42.

FIG. 45 is a partial enlarged schematic diagram of a region D4 in FIG. 24.

FIG. 46 is a partial sectional view along a U-U' direction in FIG. 45.

FIG. 47 is a partial schematic diagram of a first fan-out region after a second gate metal layer is formed in FIG. 45.

FIG. 48 is a partial schematic diagram of a first fan-out region after a first source-drain metal layer is formed in FIG. 45.

FIG. 49 is a partial schematic diagram of a second bezel area according to at least one embodiment of the present disclosure.

FIG. 50 is an exemplary schematic diagram of a second compensation unit according to at least one embodiment of the present disclosure.

FIG. 51 is a schematic diagram of a first gate metal layer in FIG. 50.

FIG. 52 is a schematic diagram of a second gate metal layer in FIG. 50.

FIG. 53 is a schematic diagram of connection of a third compensation unit according to at least one embodiment of the present disclosure.

FIG. 54 is another schematic diagram of a first bezel area according to at least one embodiment of the present disclosure.

FIG. 55 is a schematic diagram of a display device according to at least one embodiment of the present disclosure.

Detailed Description

The embodiments of the present disclosure will be described below with reference to the drawings in detail. Implementation modes may be practiced in multiple different forms. Those of ordinary skills in the art may easily understand such a fact that implementation modes and contents may be transformed into other forms without departing from the purpose and scope of the present disclosure. Therefore, the present disclosure should not be explained as being limited to the contents recorded in the following implementation modes only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one implementation mode of the present disclosure is not necessarily limited to the size, and a shape and a size of one or more components in the drawings do not reflect an actual scale. In addition, the drawings schematically illustrate ideal examples, and one implementation mode of the present disclosure is not limited to shapes, numerical values, or the like shown in the drawings.

Ordinal numerals such as "first", "second", "third", in the specification are set not to form limitations on number but only to avoid confusion between composition elements. In the present disclosure, "a plurality of/multiple" represents two or more than two.

In the specification, for convenience, expressions such as "central", "above", "below", "front", "back", "vertical", "horizontal", "top", "bottom", "inside", "outside", indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be understood as limitations on the present disclosure. The positional relationships between the constituent elements are changed as appropriate according to a direction according to which the constituent elements are described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be a fixed connection, a detachable connection, or an integrated connection; it may be a mechanical connection or a connection; it may be a direct connection, an indirect connection through a middleware, or an internal communication between two components. Those of ordinary skills in the art may understand meanings of the above-mentioned terms in the present disclosure according to situations.

In the specification, "electrical connection" includes connection of composition elements through an element with a certain electrical effect. The "element with the certain electrical effect" is not particularly limited as long as electrical signals between the connected constituent elements can be transmitted. Examples of the "element having the certain electrical effect" not only include electrodes and wirings, but also include switch elements such as transistors, resistors, inductors, capacitors, other elements with various functions, etc.

In the specification, a transistor refers to an element which at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. In the specification, the channel region refers to a region through which a current mainly flows.

In the specification, a first electrode may be a drain electrode and a second electrode may be a source electrode, or, a first electrode may be a source electrode and a second electrode may be a drain electrode. In a case that transistors with opposite polarities are used, or in a case that a direction of a current is changed during operation of a circuit, or the like, functions of the "source electrode" and the "drain electrode" are sometimes interchangeable. Therefore, the "source electrode" and the "drain electrode" are interchangeable in the specification. In addition, the gate may also be referred to as a control electrode.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In this specification, a circle, oval, triangle, rectangle, trapezoid, pentagon or hexagon, etc. is not strictly speaking, but may be an approximate circle, oval, triangle, rectangle, trapezoid, pentagon or hexagon, etc. Some small deformations due to tolerances may exist, for example, guide angles, curved edges and deformations thereof may exist.

In the present disclosure, "about" and "substantially" refer to that a boundary is not defined strictly and a case within a range of process and measurement errors is allowed. In the present disclosure, "substantially the same" refers to a case where values differ by less than 10%.

In the present disclosure, "A extends in a B direction" means that A may include a main portion and a secondary portion connected with the main body portion, the main body portion is a line, a line segment, or a strip-shaped body, the main body portion extends in the B direction, and a length of the main body portion extending in the B direction is greater than a length of the secondary portion extending in another direction. "A extends in in the B direction" in the present disclosure means "the main portion of A extends in the B direction".

With development of information society, demands for display devices for displaying various images are gradually increasing. For example, demands for medium-sized and large-sized display devices and display devices with a high resolution and a high refresh rate are gradually increasing. Medium-sized and large-sized display devices with a high resolution and a high refresh rate have increased data loads, and there is a problem that pixel charging time is relatively short.

An embodiment provides a display substrate, which includes a base substrate, a plurality of data lines, a plurality of sub-pixels, a plurality of data lead-out lines, and at least one first compensation unit. The base substrate includes a display area and a first bezel area located on one side of the display area. The plurality of data lines and the plurality of sub-pixels are located in the display area. The plurality of sub-pixels are electrically connected with the plurality of data lines. The plurality of data lead-out lines are located in the first bezel area and electrically connected with the plurality of data lines in the display area. The at least one first compensation unit is located in the first bezel area and is electrically connected with at least one data lead-out line. The at least one first compensation unit is configured to compensate at least one of resistance and capacitance of a data line with which the at least one data lead-out line is electrically connected.

In the display substrate according to the embodiment, at least one of resistance and capacitance of a data line is compensated by a first compensation unit, so that load consistency of the plurality of data lines may be improved to ensure a display effect. Furthermore, data load of a large-sized display substrate may be verified on a small-sized display substrate by using the first compensation unit, thus reducing development costs.

In some exemplary implementation modes, the display substrate of this embodiment may be a Liquid Crystal Display (LCD), an Organic Light-Emitting Diode (OLED) display, a Plasma Display Panel (PDP), or a Field Emission Display (FED). However, a type of the display substrate is not limited in the present embodiment.

In some exemplary implementation modes, the first compensation unit may include at least one of the following: at least one first compensation resistor and at least one first compensation capacitor. The at least one first compensation resistor may be configured to compensate resistance of a data line with which at least one data lead-out line is electrically connected, and the first compensation capacitor may be configured to compensate capacitance of a data line with which at least one data lead-out line is electrically connected. For example, the first compensation unit may include at least one first compensation resistor; or, the first compensation unit may include at least one first compensation capacitor; or, the first compensation unit may include at least one first compensation resistor and at least one first compensation capacitor. However, this embodiment is not limited thereto.

In some exemplary implementation modes, the at least one first compensation resistor included in the first compensation unit may be electrically connected in series with a data lead-out line. For example, the at least one first compensation resistor may include a resistor trace, and the resistor trace may be located in a first gate metal layer or a second gate metal layer, and the first gate metal layer and the second gate metal layer are different layers. In some examples, an orthographic projection of the resistor trace of the first compensation unit on the base substrate may be a serpentine trace to provide a relatively large compensation resistance. Among them, the serpentine trace is a bending curve. For example, after one end of the trace extends in one direction for a certain distance, it bends circuitously and extends in an opposite direction of this direction for a certain distance, bends circuitously again and extends in this direction, and repeatedly bends circuitously in this way for several times to form a serpentine trace. Or, the orthographic projection of the resistor trace of the first compensation unit on the base substrate may be a linear trace. However, this embodiment is not limited thereto.

In some exemplary implementation modes, a first compensation capacitor included in the first compensation unit may include a first electrode and a second electrode. The first electrode of the first compensation capacitor may be electrically connected with at least one first compensation resistor, and the second electrode of the first compensation capacitor may be electrically connected with a ground terminal. For example, second electrode(s) of at least one first compensation capacitor may be of an integral structure.

In some exemplary implementation modes, the first bezel area may include a first fan-out region located on one side of the display area. The first fan-out region may be provided with at least one dam spacer. A data lead-out line may include a first data fan-out line and a second data fan-out line which are located in the first fan-out region and electrically connected with each other. The second data fan-out line may be located on a side of the first data fan-out line away from the display area. The second data fan-out line may be located on a side of the first data fan-out line close to the base substrate. A connection position of the first data fan-out line and the second data fan-out line may be located on a side of the at least one dam spacer close to the display area, and an orthographic projection of the connection position on the base substrate is not overlapped with an orthographic projection of the at least one dam spacer on the base substrate. In this example, the first data fan-out line and the second data fan-out line are connected with each other in the first fan-out region, and the connection position of the first data fan-out line and the second data fan-out line are disposed on a side of the at least one dam spacer close to the display area, so that water vapor may be avoided from being introduced into the display area.

The display substrate of the present embodiment will now be described through some examples. The display substrate is described in the following exemplary embodiments taking an OLED display substrate as an example. Among them, since a quantity of data lines in the display area and a quantity of data fan-out lines in the first bezel area are usually large, only part of the data lines and data fan-out lines are illustrated or only a position of the first bezel area is illustrated in the drawings, and the quantity of the data lines and the quantity of the data fan-out lines are not limited.

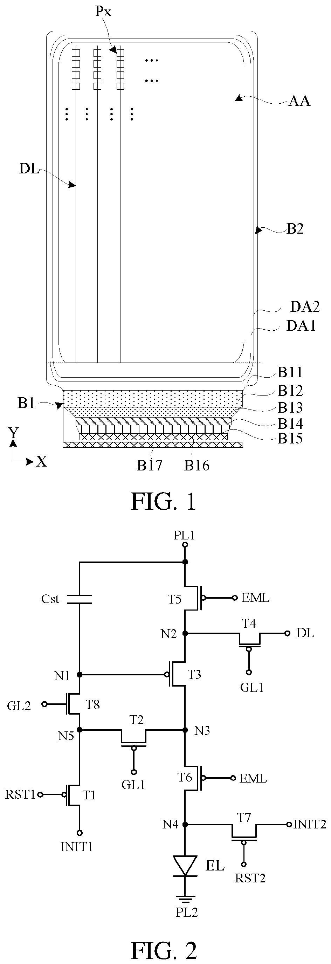

FIG. 1 is a schematic diagram of a display substrate according to at least one embodiment of the present disclosure. In some examples, as shown in FIG. 1, the display substrate of this example may include a display area AA and a bezel area located around the display area AA. The bezel area may include a first bezel area B1 located on a side of the display area AA and a second bezel area B2 located on remaining sides of the display area AA. The first bezel area B1 and the second bezel area B2 may surround the display area AA after being communicated. In some examples, the first bezel area B1 is a lower border of the display substrate, and the second bezel area B2 may include an upper border, a left border, and a right border of the display substrate. However, this embodiment is not limited thereto.

In some examples, as shown in FIG. 1, the display area AA may include a plurality of sub-pixels Px constituting a pixel array, the plurality of sub-pixels Px may be configured to display a dynamic picture or a static image, and the display area AA may be referred to as an Active Area (AA). In some examples, the display substrate may be a flexible substrate, and accordingly the display substrate may be deformed, for example, may be crimped, bent, folded, or curled.

In some examples, as shown in FIG. 1, the display area AA may further include a plurality of gate lines (not shown in the figure) and a plurality of data lines DL. The gate lines may extend in a first direction X and the data lines DL may extend in a second direction Y. The first direction X intersects with the second direction Y, for example, the first direction X may be perpendicular to the second direction Y. Orthographic projections of the plurality of gate lines and the plurality of data lines DL on the base substrate may intersect to form a plurality of sub-pixel regions, and one sub-pixel Px is disposed in each sub-pixel region. The plurality of data lines DL are electrically connected with the plurality of sub-pixels Px and the plurality of data lines DL may be configured to provide data signals to the plurality of sub-pixels Px. The plurality of gate lines are electrically connected with the plurality of sub-pixels Px, and are configured to provide scan signals to the plurality of sub-pixels Px.

In some examples, one pixel unit may include three sub-pixels, which are respectively a red sub-pixel, a green sub-pixel, and a blue sub-pixel. However, this embodiment is not limited thereto. In some examples, one pixel unit may include four sub-pixels, and the four sub-pixels are a red sub-pixel, a green sub-pixel, a blue sub-pixel, and a white sub-pixel respectively.

In some examples, a shape of a sub-pixel may be a rectangle, a rhombus, a pentagon, or a hexagon. When one pixel unit includes three sub-pixels, the three sub-pixels may be arranged in parallel in a horizontal direction, in parallel in a vertical direction, or in a delta-shaped form. When one pixel unit includes four sub-pixels, the four sub-pixels may be arranged in parallel in a horizontal direction, in parallel in a vertical direction, or in a square. However, this embodiment is not limited thereto.

In some examples, at least one sub-pixel may include a pixel circuit and a light emitting element. The pixel circuit may be configured to drive a light emitting element connected thereto. For example, the pixel circuit may be configured to provide a driving current for driving the light emitting element to emit light. The pixel circuit may include a plurality of transistors and at least one capacitor, for example, the pixel circuit may be of a 3T1C, 4T1C, 5T1C, 5T2C, 6T1C, 7T1C, or 8T1C structure. Among them, in the above circuit structures, T refers to a thin film transistor, C refers to a capacitor, a number before T represents a quantity of thin film transistors in the circuit, and a number before C represents a quantity of capacitors in the circuit.

In some examples, the plurality of transistors in the pixel circuit may be P-type transistors or may be N-type transistors. Using a same type of transistors in a pixel circuit may simplify a process flow, reduce a process difficulty of the display substrate, and improve a yield of products. In some other examples, the plurality of transistors in the pixel circuit may include a P-type transistor and an N-type transistor.

In some examples, low temperature polysilicon thin film transistors, or oxide thin film transistors, or a low temperature polysilicon thin film transistor and an oxide thin film transistor, may be used as a plurality of transistors in a pixel circuit. An active layer of a low temperature poly-crystalline silicon thin film transistor is made of Low Temperature Poly-crystalline Silicon (LTPS), and an active layer of an oxide thin film transistor is made of an oxide semiconductor (Oxide). The low temperature poly silicon thin film transistor has advantages such as a high migration rate and fast charging, and the oxide thin film transistor has advantages such as a low leakage current. The low temperature poly silicon thin film transistor and the oxide thin film transistor are integrated on one display substrate, that is, an LTPS + Oxide (LTPO for short) display substrate, so that advantages of the low temperature poly silicon thin film transistor and the oxide thin film transistor may be utilized, low-frequency drive may be achieved, power consumption may be reduced, and display quality may be improved.

In some examples, the light emitting element may be an Organic Light Emitting Diode (OLED), and the light emitting element emits red light, green light, blue light, or white light, etc., when driven by a pixel circuit corresponding to the light emitting element. A color of light emitted from the light emitting element may be determined as required. The light emitting element may include an anode, a cathode and an organic light emitting layer disposed between the anode and the cathode. The anode of the light emitting element may be electrically connected with a corresponding pixel circuit. However, this embodiment is not limited thereto.

FIG. 2 is an equivalent circuit diagram of a pixel circuit according to at least one embodiment of the present disclosure. In some examples, as shown in FIG. 2, the pixel circuit of this example may be of a structure of 8T1C, i.e., including a first transistor T1 to a seventh transistor T8 and a storage capacitor Cst. In this example, the first transistor T1 is also referred to as a first reset transistor, the second transistor T2 is also referred to as a threshold compensation transistor, the third transistor T3 is also referred to as a drive transistor, the fourth transistor T4 is also referred to as a data writing transistor, the fifth transistor T5 is also referred to as a first light emitting control transistor, the sixth transistor T6 is also referred to as a second light emitting control transistor, and the seventh transistor T7 is also referred to as a second reset transistor.

In some examples, the first transistor T1 to the seventh transistor T7 of the pixel circuit may be first type transistors, such as P-type transistors, and the eighth transistor T8 may be a second type transistor, such as an N-type transistor. However, this embodiment is not limited thereto. For example, the plurality of transistors of the first pixel circuit may be all P-type transistors or may be all N-type transistors.

In some examples, low temperature polysilicon thin film transistors may be used as the first transistor T1 to the seventh transistor T7 of the pixel circuit, and an oxide thin film transistor may be used as the eighth transistor T8 of the pixel circuit. However, this embodiment is not limited thereto.

In some examples, as shown in FIG. 2, the pixel circuit may be electrically connected with a first scan line GL1, a second scan line GL2, a data line DL, a first power supply line PL1, a second power supply line PL2, a light emitting control line EML, a first initial signal line INIT1, a second initial signal line INIT2, a first reset control line RST1, and a second reset control line RST2. In some examples, the first power supply line PL1 may be configured to provide a constant first voltage signal VDD to a pixel circuit, the second power supply line PL2 may be configured to provide a constant second voltage signal VSS to a pixel circuit, and the first voltage signal VDD is greater than the second voltage signal VSS. The first scan line GL1 may be configured to provide a first scan signal SCAN1 to the pixel circuit, the second scan line GL2 may be configured to provide a second scan signal SCAN2 to the pixel circuit, the data line DL may be configured to provide a data signal to the pixel circuit, the light emitting control line EML may be configured to provide a light emitting control signal EM to the pixel circuit, the first reset control line RST1 may be configured to provide a first reset control signal RESET1 to the pixel circuit, and the second reset control line RST2 may be configured to provide a second reset signal RESET2 to the pixel circuit.

In some examples, in a pixel circuit of an n-th row, a first reset control line RST1 may be electrically connected with a first scan line GL1 of a pixel circuit of an (n-1)-th row to be inputted with a first scan signal SCAN1(n-1), that is, a first reset control signal RESET1(n) is the same as the first scan signal SCAN1(n-1). A second reset control line RST2 may be electrically connected with a first reset control line RST1 of a pixel circuit of an (n+1)-th row to be inputted with a first scan signal SCAN1(n), that is, a second reset control signal RESET2(n) is the same as the first scan signal SCAN1(n). Thus, signal lines of the display substrate may be reduced, and a narrow bezel of the display substrate may be achieved.

In some examples, as shown in FIG. 2, a gate of the third transistor T3 is electrically connected with a first node N1, a first electrode of the third transistor T3 is electrically connected with a second node N2, and a second electrode of the third transistor T3 is electrically connected with a third node N3. A gate electrode of the fourth transistor T4 is electrically connected with the first scan line GL1, a first electrode of the fourth transistor T4 is electrically connected with the data line DL, and a second electrode of the fourth transistor T4 is electrically connected with the second node N2. A gate of the second transistor T2 is electrically connected with the first scan line GL1, a first electrode of the second transistor T2 is electrically connected with a fifth node N5, and a second electrode of the second transistor T2 is electrically connected with the third node N3. A gate of the fifth transistor T5 is electrically connected with the light emitting control line EML, a first electrode of the fifth transistor T5 is electrically connected with the first power supply line PL1, and a second electrode of the fifth transistor T5 is electrically connected with the second node N2. A gate of the sixth transistor T6 is electrically connected with the light emitting control line EML, a first electrode of the sixth transistor T6 is electrically connected with the third node N3, and a second electrode of the sixth transistor T6 is electrically connected with a fourth node N4. A gate of the first transistor T1 is electrically connected with the first reset control line RST1, a first electrode of the first transistor T1 is electrically connected with the first initial signal line INIT1, and a second electrode of the first transistor T1 is electrically connected with the fifth node N5. A gate electrode of the seventh transistor T7 is electrically connected with the second reset control line RST2, a first electrode of the seventh transistor T7 is electrically connected with the second initial signal line INIT2, and a second electrode of the seventh transistor T7 is electrically connected with the fourth node N4. A gate of the eighth transistor T8 is electrically connected with the second scan signal line GL2, a first electrode of the eighth transistor T8 is electrically connected with the fifth node N5, and a second electrode of the eighth transistor T8 is electrically connected with the first node N1. A first electrode of the storage capacitor Cst is electrically connected with the first node N1, and a second electrode of the storage capacitor Cst is electrically connected with the first power supply line PL1.

In this example, the first node N1 is a connection point of the storage capacitor Cst, the eighth transistor T8, and the third transistor T3. The second node N2 is a connection point of the fifth transistor T5, the fourth transistor T4, and the third transistor T3. The third node N3 is a connection point of the third transistor T3, the second transistor T2, and the sixth transistor T6. The fourth node N4 is a connection point of the sixth transistor T6, the seventh transistor T7, and the light emitting element EL. The fifth node N5 is a connection point of the first transistor T1, the second transistor T2, and the eighth transistor T8.

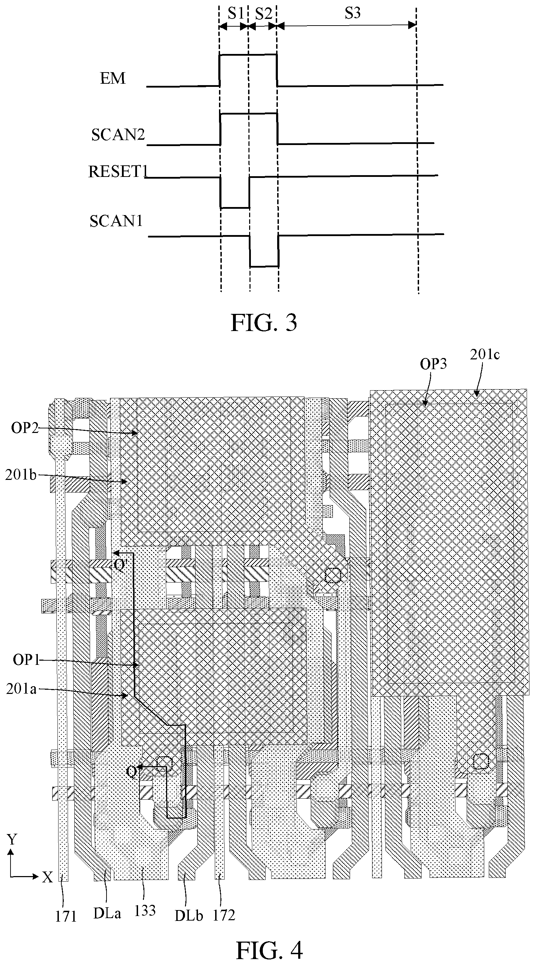

FIG. 3 is an operating timing diagram of the pixel circuit shown in FIG. 2. In some examples, as shown in FIG. 3, during one frame of display period, an operating process of the pixel circuit may include a first stage S1, a second stage S2, and a third stage S3. In this example, a second reset control signal received by one row of pixel circuits may be the same as a first scan signal.

In the first stage S1, which is is referred to as a reset stage, a first reset control signal RESET 1 provided by the first reset control line RST is a low-level signal to turn on the first transistor T1, and a second scan signal SCAN2 provided by the second scan line GL2 is a high-level signal to turn on the eighth transistor T8. A first initial signal provided by the first initial signal line INIT1 is provided to the fifth node N5 and the first node N1 to initialize the first node N1 and clear an original data voltage in the storage capacitor Cst. A first scan signal SCAN1 provided by the first scan line GL1 is a high-level signal, and a light emitting control signal EM provided by the light emitting control line EML is a high-level signal, so that the fourth transistor T4, the second transistor T2, the seventh transistor T7, the fifth transistor T5 and the sixth transistor T6 are turned off. In this stage, the light emitting element EL does not emit light.

In the second stage S2, which is is referred to as a data writing stage or a threshold compensation stage, The first scan signal SCAN1 provided by the first scan line GL1 is a low-level signal, all of the second scan signal SCAN2 provided by the second scan line GL2, the first reset control signal RESET1 provided by the first reset control line RST, and the light emitting control signal EM provided by the light emitting control line EML are high-level signals, and the data line DL outputs a data signal. In this stage, the third transistor T3 is turned on because the first electrode of the storage capacitor Cst is at a low-level. The first scan signal line SCAN1 is the low-level signal, so that the second transistor T2, the fourth transistor T4, and the seventh transistor T7 are turned on. The second transistor T2, the fourth transistor T4, and the eighth transistor T8 are turned on, so that a data voltage Vdata outputted by the data line DL is provided to the first node N1 through the second node N2, the turned-on third transistor T3, the third node N3, the turned-on second transistor T2, the fifth node N5, and the turned-on eighth transistor T8, and a difference between the data voltage Vdata outputted by the data line DL and a threshold voltage of the third transistor T3 is charged into the storage capacitor Cst, wherein a voltage at the first electrode (i.e., the first node N1) of the storage capacitor Cst is Vdata-IVthI, Vdata is the data voltage outputted by the data line DL, and Vth is the threshold voltage of the third transistor T3. The seventh transistor T7 is turned on, so that a second initial signal provided by the second initial signal line INIT2 is provided to the fourth node N4 to initialize (reset) an anode of a light emitting element EL and clear its internal pre-stored voltage, so as to complete initialization, and ensure that the light emitting element EL does not emit light. The first reset control signal RESET 1 provided by the first reset control line RST1 is a high-level signal, so that the first transistor T1 is turned off. The light emitting control signal EM provided by the light emitting control line EML is a high-level signal, so that the fifth transistor T5 and the sixth transistor T6 are turned off.

In the third stage S3, which is referred to as a light-emitting stage, the light emitting control signal EM provided by the light emitting control line EML is a low-level signal, so that the fifth transistor T5 and the sixth transistor T6 are turned on. The second scan signal SCAN2 provided by the second scan line GL2 is a low-level signal, so that the eighth transistor T8 is turned off. The first scan signal SCAN1 provided by the first scan line GL1 and the first reset control signal RESET1 provided by the first reset control line RST1 are high-level signals, so that the second transistor T2, the fourth transistor T4, the seventh transistor T7, and the first transistor T1 are turned off. A first voltage signal VDD outputted by the first power supply line PL1 provides a drive voltage to the anode of the light emitting element EL through the turned-on fifth transistor T5, the third transistor T3, and the sixth transistor T6, to drive the light emitting element EL to emit light.

In a drive process of the pixel circuit, a drive current flowing through the third transistor T3 is determined by a voltage difference between the control electrode and the first electrode of the third transistor T3. Since the voltage of the first node N1 is Vdata-|Vth|, the drive current of the third transistor T3 is as follows.

$$I=K\times(Vgs-Vth)^2=K\times[(VDD-Vdata+|Vth|)-Vth]^2=K\times[VDD-Vdata]^2$$

Herein, I is the drive current flowing through the third transistor T3, that is, a drive current for driving the light emitting element, K is a constant, Vgs is the voltage difference between the control electrode and the first electrode of the third transistor T3, Vth is the threshold voltage of the third transistor T3, Vdata is the data voltage outputted by the data line DL, and VDD is the first voltage signal outputted by the first power supply line PL1.

It may be seen from the above formula that a current flowing through the light emitting element is independent of the threshold voltage of the third transistor T3. Therefore, the pixel circuit according to this embodiment may better compensate the threshold voltage of the third transistor T3.

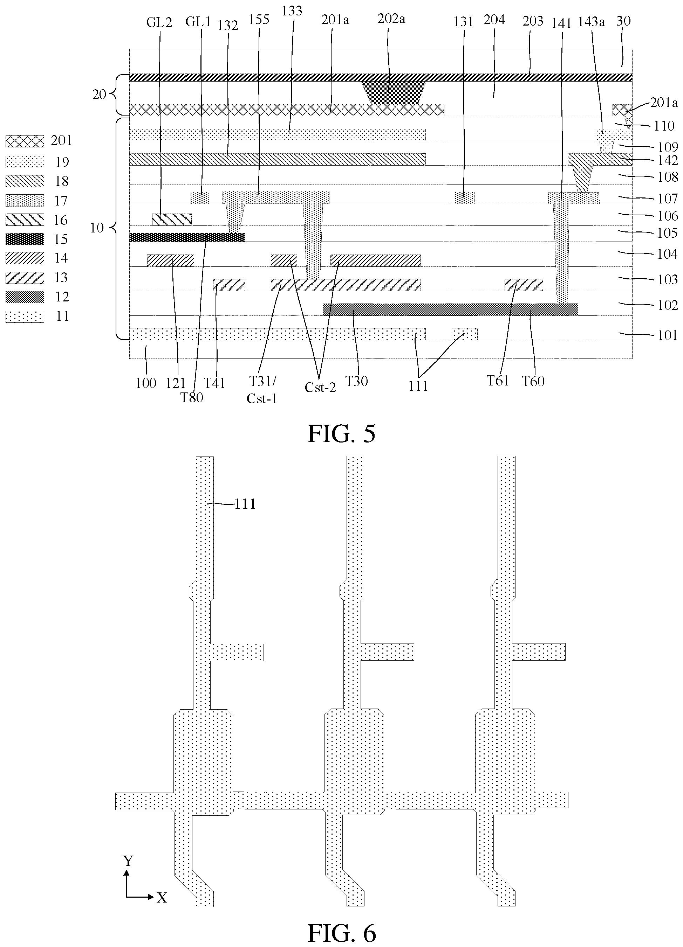

FIG. 4 is a schematic partial plan view of a display area according to at least one embodiment of the present disclosure. FIG. 5 is a schematic partial cross-section view along a Q-Q' direction in FIG. 4. In FIG. 4, three sub-pixels are taken as an example for illustration. In this example, the pixel circuit is schematically illustrated by taking the 8T1C structure shown in FIG. 2 as an example. In some examples, as shown in FIG. 4, in a direction parallel to the display substrate, the three sub-pixels may be arranged in a delta-shaped form.

In some examples, as shown in FIG. 5, in a direction perpendicular to the display substrate, the display area may include a base substrate 100, and a circuit structure layer 10, a light emitting structure layer 20, and an encapsulation structure layer 30 which are sequentially disposed on the base substrate 100. The circuit structure layer 10 may include a light shielding (LS) layer 11, a first semiconductor layer 12, a first gate metal layer 13, a second gate metal layer 14, a second semiconductor layer 15, a third gate metal layer 16, a first source-drain metal layer 17, a second source-drain metal layer 18, and a third source-drain metal layer 19 that are sequentially disposed on the base substrate 100. A first insulation layer 101 is disposed between the light shielding layer 11 and the first semiconductor layer 12, a second insulation layer 102 is disposed between the first semiconductor layer 12 and the first gate metal layer 13, a third insulation layer 103 is disposed between the first gate metal layer 13 and the second gate metal layer 14, a fourth insulation layer 104 is disposed between the second gate metal layer 14 and the second semiconductor layer 15, a fifth insulation layer 105 is disposed between the second semiconductor layer 15 and the third gate metal layer 16, a sixth insulation layer 106 is disposed between the third gate metal layer 16 and the first source-drain metal layer 17, a seventh insulation layer 107 and an eighth insulation layer 108 are disposed between the first source-drain metal layer 17 and the second source-drain metal layer 18, a ninth insulation layer 109 is disposed between the second source-drain metal layer 18 and the third source-drain metal layer 19, and a tenth insulation layer 110 is disposed between the third source-drain metal layer 19 and the light emitting structure layer 20. In some examples, the first insulation layer 101 to the seventh insulation layer 107 may be inorganic insulation layers, and the eighth insulation layer 108 to the tenth insulation layer 110 may be organic insulation layers. However, this embodiment is not limited thereto.

In some examples, as shown in FIGs. 4 and 5, the light emitting structure layer 20 may include an anode layer 201 (e.g., may include anodes 201a, 201b, and 201c), a pixel definition layer 204, an organic emitting layer (e.g., may include an organic emitting layer 202a), and a cathode layer 203 that are sequentially disposed on the base substrate 100. The pixel definition layer 204 may be provided with a plurality of pixel openings (e.g., pixel openings OP1, OP2, and OP3). An orthographic projection of the pixel opening OP1 on the base substrate may be within a range of an orthographic projection of the anode 201a on the base substrate and the pixel opening OP1 may expose a portion of a surface of the anode 201a. An orthographic projection of the pixel opening OP2 on the base substrate may be within a range of an orthographic projection of the anode 201b on the base substrate and the pixel opening OP2 may expose a portion of a surface of the anode 201b. An orthographic projection of the pixel opening OP3 on the base substrate may be within a range of an orthographic projection of the anode 201c on the base substrate and the pixel opening OP3 may expose a portion of a surface of the anode 201c. The organic emitting layer 202a may be located within the pixel opening OP1. The cathode layer 203 may be in direct contact with the organic emitting layer 202a.

FIG. 6 is a schematic diagram of the display area after a light shielding layer is formed in FIG. 4. In some examples, as shown in FIG. 4 to FIG. 6, the light shielding layer 11 of the display area may include a plurality of light shielding traces 111. The plurality of light shielding traces 111 may be of an integral structure. The plurality of light shielding traces 111 may be electrically connected along the first direction X and the second direction Y and a mesh connection structure may be formed in the display area.

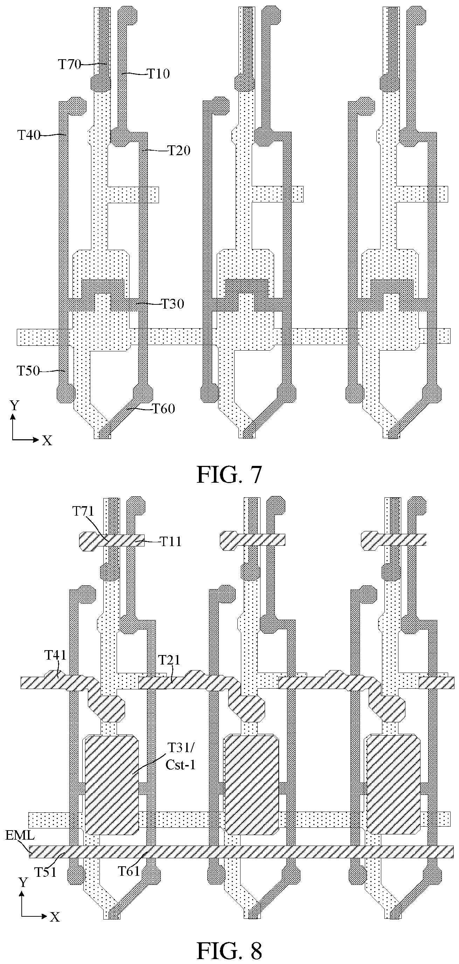

FIG. 7 is a schematic diagram of the display area after a first semiconductor layer is formed in FIG. 4. In some examples, as shown in FIG. 4 to FIG. 7, the first semiconductor layer 12 of the display area may include active layers of a plurality of first type transistors of a plurality of pixel circuits (for example, may include an active layer T10 of the first transistor T1, an active layer T20 of the second transistor T2, an active layer T30 of the third transistor T3, an active layer T40 of the fourth transistor T4, an active layer T50 of the fifth transistor T5, an active layer T60 of the sixth transistor T6, and an active layer T70 of the seventh transistor T7). In this example, illustration is made by taking a first transistor T1 to a sixth transistor T6 of a pixel circuit of a present row and a seventh transistor T7 of a pixel circuit of a previous row as examples. In some examples, an active layer T10 of a first transistor T1 to an active layer T70 of a seventh transistor T7 of a pixel circuit may be connected with each other to form an integral structure.

In some examples, a material of the first semiconductor layer 12 may include polysilicon for example. An active layer of any transistor may include at least one channel region and a plurality of doped regions. The channel region may not be doped with an impurity, and has characteristics of a semiconductor. The plurality of doped regions may be on two sides of the channel region and doped with impurities, and thus have conductivity. The impurities may be changed according to a type of the transistor. In some examples, a doped region of the active layer may be interpreted as a source or a drain of a transistor. A portion of an active layer between the transistors may be interpreted as a wiring doped with an impurity, and may be used for electrically connecting the transistors.

In some examples, as shown in FIGs. 6 and 7, an orthographic projection of a light shielding trace 111 on the base substrate may cover an orthographic projection of a channel region of the active layer T30 of the third transistor T3 on the base substrate, thereby protecting the third transistor T3 and preventing an external environment from affecting performance of the third transistor T3.

FIG. 8 is a schematic diagram of the display area after a first gate metal layer is formed in FIG. 4. In some examples, as shown in FIG. 4 to FIG. 8, the first gate metal layer 13 of the display area may include gates of a plurality of first type transistors of a plurality of pixel circuits (for example, may include a gate T11 of the first transistor T1, a gate T21 of the second transistor T2, a gate T31 of the third transistor T3, a gate T41 of the fourth transistor T4, a gate T51 of the fifth transistor T5, a gate T61 of the sixth transistor T6, and a gate T71 of the seventh transistor T7), first electrodes Cst-1 of storage capacitors Cst of the plurality of pixel circuits, and a light emitting control line EML.

In some examples, as shown in FIG. 8, a first electrode Cst-1 of a storage capacitor Cst and the gate T31 of the third transistor T3 may be of an integral structure, for example, may be a rectangle, such as a rounded rectangle. A gate T11 of a first transistor T1 of a pixel circuit of the present row and a gate T71 of a seventh transistor T7 of a pixel circuit of a previous row may be of an integral structure. A gate T21 of a second transistor T2 of a pixel circuit of a present column and a gate T41 of a fourth transistor T4 of a pixel circuit of an adjacent column may be of an integral structure. The gate T51 of the fifth transistor T5, the gate T61 of the sixth transistor T6, and the light emitting control line EML may be of an integral structure. However, this embodiment is not limited thereto.

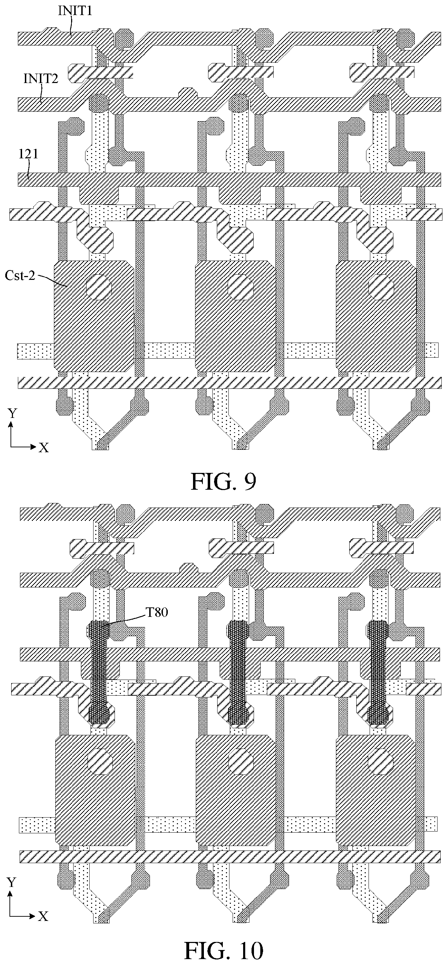

FIG. 9 is a schematic diagram of the display area after a second gate metal layer is formed in FIG. 4. In some examples, as shown in FIG. 4 to FIG. 9, the second gate metal layer 14 of the display area may include second electrodes Cst-2 of storage capacitors Cst of a plurality of pixel circuits, a first initial signal line INIT1, a second initial signal line INIT2, and a scan connection line 121. The first initial signal line INIT1, the second initial signal line INIT2, and the scan connection line 121 may all extend in the first direction X. In the second direction Y, the second initial signal line INIT2 may be located between the first initial signal line INIT1 and the scan connection line 121.

FIG. 10 is a schematic diagram of the display area after a second semiconductor layer is formed in FIG. 4. In some examples, as shown in FIG. 4 to FIG. 10, the second semiconductor layer 15 of the display area may include active layers of second type transistors of a plurality of pixel circuits (for example, may include an active layer T80 of the eighth transistor T8). The active layer T80 of the eighth transistor T8 may extend in the second direction Y. In some examples, a material of the second semiconductor layer 15 may include a metal oxide such as Indium Gallium Zinc Oxide (IGZO).

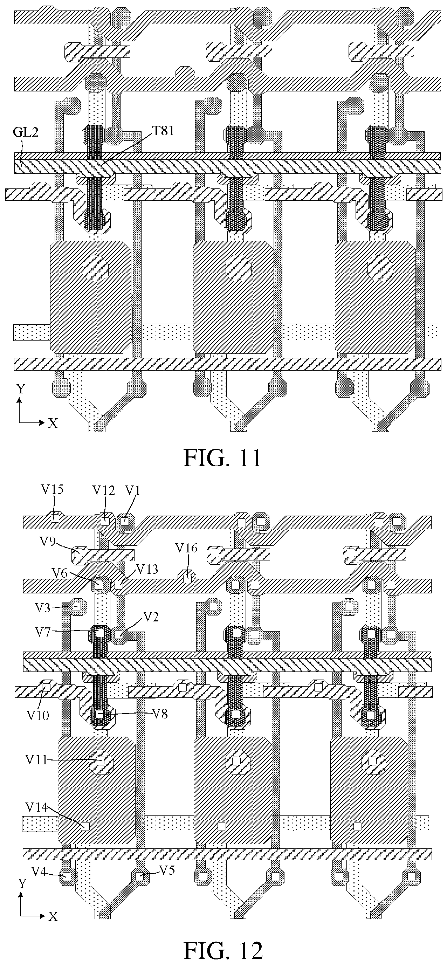

FIG. 11 is a schematic diagram of the display area after a third gate metal layer is formed in FIG. 4. In some examples, as shown in FIG. 4 to FIG. 11, the third gate metal layer 16 of the display area may include a gate of a second type transistor (e.g., may include a gate T81 of the eighth transistor T8) and a second scan line GL2. The second scan line GL2 may extend in the first direction X. The gate T81 of the eighth transistor T8 and the second scan line GL2 may be of an integral structure. In some examples, the gate T81 of the eighth transistor T8 may be a top gate, and an overlapping region of the scan connection line 121 and the active layer T80 of the eighth transistor T8 may serve as a bottom gate of the eighth transistor T8. The scan connection line 121 may also be configured to shield light for a channel region of the active layer T80 of the eighth transistor T8 to ensure performance of the eighth transistor T8.

FIG. 12 is a schematic diagram of the display area after a sixth insulation layer is formed in FIG. 4. In some examples, as shown in FIG. 4 to FIG. 12, the sixth insulation layer 106 of the display area may be provided with a plurality of vias, which, for example, may include a plurality of first type vias (e.g., including a first via V1 to a sixth via V6) exposing a surface of the first semiconductor layer 12, a plurality of second type vias (e.g., including a seventh via V7 and an eighth via V8) exposing a surface of the second semiconductor layer 15, a plurality of third type vias (e.g., including a ninth via V9 to an eleventh via V11) exposing a surface of the first gate metal layer 13, and a plurality of fourth type vias (e.g., including a twelfth via V12 to a sixteenth via V16) exposing a surface of the second gate metal layer 14. The sixth insulation layer 106 to the second insulation layer 102 within the first type vias may be removed. The sixth insulation layer 106 to the fifth insulation layer 105 within the second type vias may be removed, the sixth insulation layer 106 to the third insulation layer 103 within the third type vias may be removed, and the sixth insulation layer 106 to the fourth insulation layer 104 within the fourth type vias may be removed.

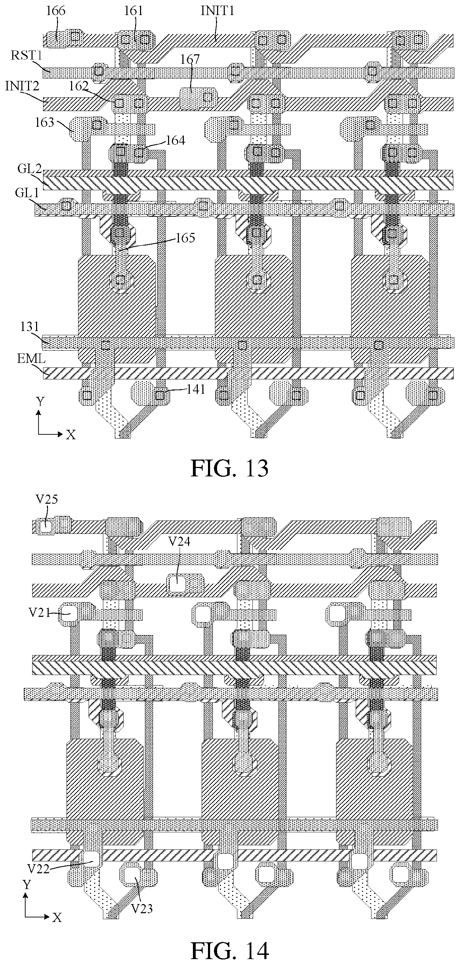

FIG. 13 is a schematic diagram of the display area after a first source-drain metal layer is formed in FIG. 4. In some examples, as shown in FIG. 4 to FIG. 13, the first source-drain metal layer 17 of the display area may include a plurality of connection electrodes (for example, may include a first connection electrode 161 to a seventh connection electrode 167, and a first anode connection electrode 141), a first scan line GL1, a first reset control line RST1, and a first power supply connection line 131. In this example, a first reset control line RST1 electrically connected with a pixel circuit of a present row and a second reset control line RST2 electrically connected with a pixel circuit of a previous row may be of an integral structure. The first scan line GL1, the first reset control line RST1, and the first power supply connection line 131 may all extend in the first direction X. In the second direction Y, the first scan line GL1 may be located between the first reset control line RST1 and the first power supply connection line 131. An orthographic projection of the first reset control line RST1 on the base substrate may be located between an orthographic projection of the first initial signal line INIT1 on the base substrate and an orthographic projection of the second initial signal line INIT2 on the base substrate.

In some examples, as shown in FIG. 4 to FIG. 13, the first connection electrode 161 may be electrically connected with one doped region of the active layer T10 of the first transistor T1 through the first via V1, and may also be electrically connected with the first initial signal line INIT1 through the twelfth via V12. A second connection electrode 162 may be electrically connected with one doped region of the active layer T70 of the seventh transistor T7 through the sixth via V6, and may also be electrically connected with the second initial signal line IINT2 through the thirteenth via V13. A third connection electrode 163 may be electrically connected with one doped region of the active layer T40 of the fourth transistor T4 through the third via V3. A fourth connection electrode 164 may be electrically connected with one doped region of the active layer T20 of the second transistor T2 through the second via V2, and may also be electrically connected with one doped region of the active layer T80 of the eighth transistor T8 through the seventh via V7. A fifth connection electrode 165 may be electrically connected with another doped region of the active layer T80 of the eighth transistor T8 through the eighth via V8, and may also be electrically connected with the gate T31 of the third transistor T3 through the eleventh via V11. A sixth connection electrode 166 may be electrically connected with the first initial signal line INIT1 through the fifteenth via V15. The seventh connection electrode 167 may be electrically connected with the second initial signal line INIT2 through the sixteenth via V16. The first anode connection electrode 141 may be electrically connected with one doped region of the active layer T60 of the sixth transistor T6 through the fifth via V5. The first reset control line RST1 may be electrically connected with the gate T11 of the first transistor T1 through the ninth via V9. The first scan line GL1 may be electrically connected with the gate T41 of the fourth transistor T4 through the tenth via V10. The first power supply connection line 131 may be electrically connected with a second electrode Cst-2 of a storage capacitor Cst through the fourteenth via V14, and may also be electrically connected with one doped region of the active layer T50 of the fifth transistor T5 through the fourth via V4. The first power supply connection line 131 may be configured to provide a first voltage signal.

FIG. 14 is a schematic diagram of the display area after an eighth insulation layer is formed in FIG. 4. In some examples, as shown in FIG. 4 to FIG. 14, the eighth insulation layer 108 of the display area may be provided with a plurality of vias, which may include a twenty-first via V21 to a twenty-fifth via V25 for example. The eighth insulation layer 108 and the seventh insulation layer 107 within the twenty-first via V21 may be removed to expose a surface of the third connection electrode 163 located in the first source-drain metal layer 17. The eighth insulation layer 108 and the seventh insulation layer 107 within the twenty-second via V22 may be removed to expose a surface of the first power supply connection line 131 located in the first source-drain metal layer 17. The eighth insulation layer 108 and the seventh insulation layer 107 within the twenty-third via V23 may be removed to expose a surface of the first anode connection electrode 141 located in the first source-drain metal layer 17. The eighth insulation layer 108 and the seventh insulation layer 107 within the twenty-fourth via V24 may be removed to expose a surface of the seventh connection electrode 167 located in the first source-drain metal layer 17. The eighth insulation layer 108 and the seventh insulation layer 107 within the twenty-fifth via V25 may be removed to expose a surface of the sixth connection electrode 166 located in the first source-drain metal layer 17.

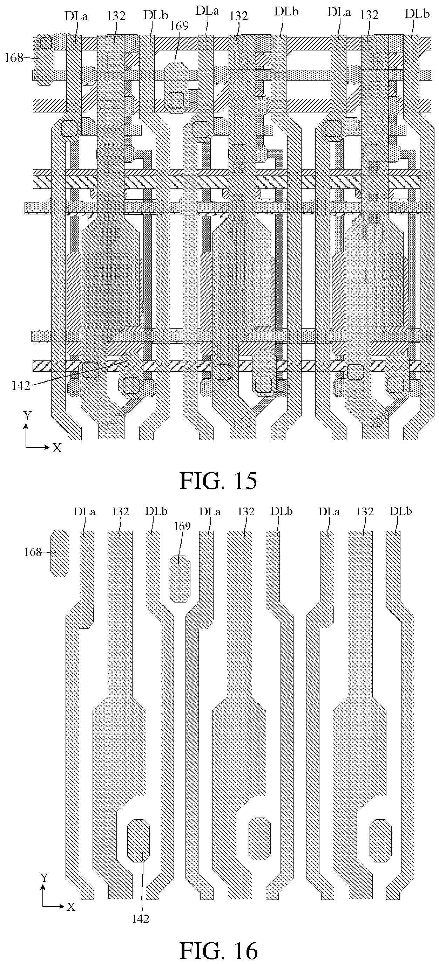

FIG. 15 is a schematic diagram of the display area after a second source-drain metal layer is formed in FIG. 4. FIG. 16 is a schematic diagram of the second source-drain metal layer in FIG. 15. In some examples, as shown in FIG. 4 to FIG. 16, the second source-drain metal layer 18 of the display area may include a plurality of data lines (e.g. including data lines DLa and DLb), a second power supply connection line 132, and a plurality of connection electrodes (e.g. including an eighth connection electrode 168, a ninth connection electrode 169, and a second anode connection electrode 142). The plurality of data lines and the second power supply connection line 132 may all extend in the second direction Y. The data line DLa may be electrically connected with a column of pixel circuits located in an odd-numbered row, and the data line DLb may be electrically connected with a column of pixel circuits located in an even-numbered row; or, the data line DLa may be electrically connected with a column of pixel circuits located in an even-numbered row, and the data line DLb may be electrically connected with a column of pixel circuits located in an odd-numbered row. The second power supply connection line 132 may be located between adjacent data lines DLa and DLb in the first direction X, and data lines DLa and DLb are arranged between two adjacent second power supply connection lines 132. In this example, a manner in which pixel circuits of odd-numbered and even-numbered rows are connected with different data lines is adopted, which may reduce load of a single data line to a certain extent.

In some examples, as shown in FIG. 4 to FIG. 16, the eighth connection electrode 168 may be electrically connected with the sixth connection electrode 166 through the twenty-fifth via V25. The ninth connection electrode 169 may be electrically connected with the seventh connection electrode 167 through the twenty-fourth via V24. The data line DLa may be electrically connected with the third connection electrode 163 through the twenty-first via V21 to achieve an electrical connection with a first electrode of a fourth transistor T4 of a pixel circuit. The second anode connection electrode 142 may be electrically connected with the first anode connection electrode 141 through the twenty-third via V23. The second power supply connection line 132 may be electrically connected with the first power supply connection line 131 through the twenty-second via V22. The data line DLb may be electrically connected with a first electrode of a fourth transistor T4 of a pixel circuit of an adjacent row.

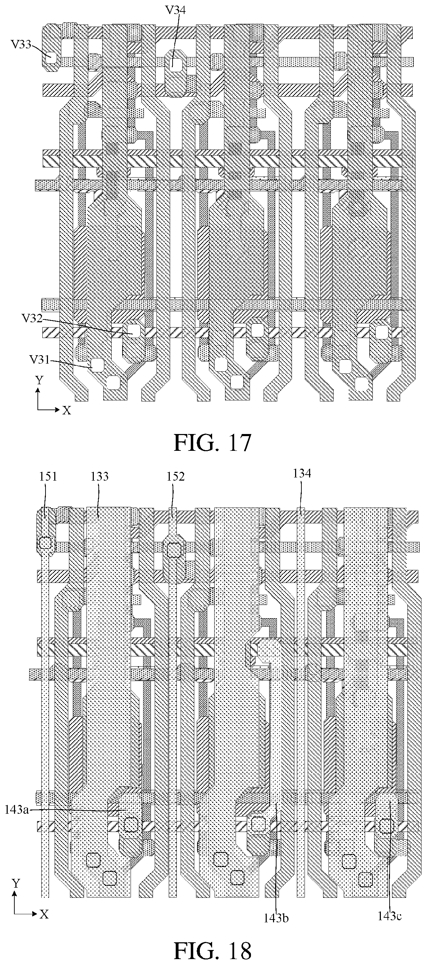

FIG. 17 is a schematic diagram of the display area after a ninth insulation layer is formed in FIG. 4. In some examples, as shown in FIG. 4 to FIG. 17, the ninth insulation layer 109 of the display area may be provided with a plurality of vias, which may include a thirty-first via V31 to a thirty-fourth via V34 for example. The ninth insulation layer 109 within the thirty-first via V31 may be removed to expose a surface of the second power supply connection line 132 located in the second source-drain metal layer 18. The ninth insulation layer 109 within the thirty-second via V32 may be removed to expose a surface of the second anode connection electrode 142 located in the second source-drain metal layer 18. The ninth insulation layer 109 within the thirty-third via V33 may be removed to expose a surface of the eighth connection electrode 168 located in the second source-drain metal layer 18. The ninth insulation layer 109 within the thirty-fourth via V34 may be removed to expose a surface of the ninth connection electrode 169 located in the second source-drain metal layer 18.

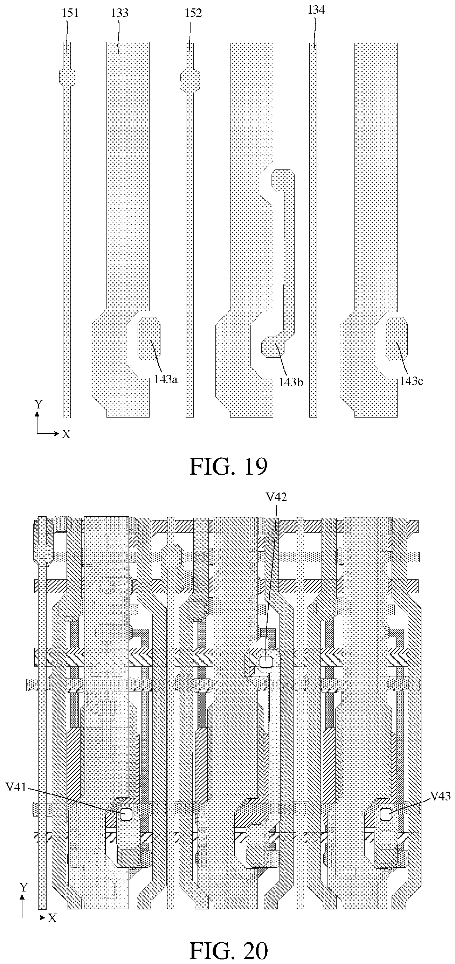

FIG. 18 is a schematic diagram of the display area after a third source-drain metal layer is formed in FIG. 4. FIG. 19 is a schematic diagram of the third source-drain metal layer in FIG. 18. In some examples, as shown in FIG. 4 to FIG. 19, the third source-drain metal layer 19 of the display area may include third power supply connection lines 133, a fourth power supply connection line 134, a first initial connection line 151, a second initial connection line 152, and third anode connection electrodes (e.g., third anode connection electrodes 143a, 143b, and 143c). The third power supply connection lines 133, the fourth power supply connection line 134, the first initial connection line 151, and the second initial connection line 152 may all extend in the second direction Y. One third power supply connection line 133 may be arranged in the first direction X between the first initial connection line 151 and the second initial connection line 152 and at an interval from the first initial connection line 151 and the second initial connection line 152. The fourth power supply connection line 134 may be located between two adjacent third power supply connection lines 133 in the first direction X.

In some examples, as shown in FIG. 4 to FIG. 19, the first initial connection line 151 may be electrically connected with the eighth connection electrode 168 through the thirty-third via V33, thereby achieving an electrical connection with the first initial signal line INIT1 through the eighth connection electrode 168 and the sixth connection electrode 166. The first initial connection line 151 and the first initial signal line INIT1 may form a mesh transmission structure of a first initial signal in the display area, thereby improving transmission stability of the first initial signal. The second initial connection line 152 may be electrically connected with the ninth connection electrode 169 through the thirty-fourth via V34, thereby achieving an electrical connection with the second initial signal line INIT2 through the ninth connection electrode 169 and the seventh connection electrode 167. The second initial connection line 152 and the second initial signal line INIT2 may form a mesh transmission structure of a second initial signal in the display area, thereby improving transmission stability of the second initial signal. The third power supply connection line 133 may be electrically connected with the second power supply connection line 132 through at least two thirty-first vias V31. In this example, the first power supply connection line 131, the second power supply connection line 132, and the third power supply connection line 133 are electrically connected and may be configured to transmit a first voltage signal VDD. The first power supply connection line 131, the second power supply connection line 132, and the third power supply connection line 133 may form a mesh transmission structure of the first voltage signal VDD in the display area, thereby reducing voltage drop of the first voltage signal at different positions and improving transmission stability of the first voltage signal. The fourth power supply connection line 134 may be configured to transmit a second voltage signal VSS. The third anode connection electrodes 143a, 143b, and 143c may each be electrically connected with one second anode connection electrode 142 through one thirty-second via V32. The third anode connection electrode 143b may extend in the second direction Y.

FIG. 20 is a schematic diagram of the display area after a tenth insulation layer is formed in FIG. 4. In some examples, as shown in FIG. 4 to FIG. 20, the tenth insulation layer 110 of the display area may be provided with a plurality of vias which may include a forty-first via V41 to a forty-third via V43 for example. The tenth insulation layer 110 within the forty-first via V41 may be removed to expose a surface of the third anode connection electrode 143a located in the third source-drain metal layer 19. The tenth insulation layer 110 within the forty-second via V42 may be removed to expose a surface of the third anode connection electrode 143b located in the third source-drain metal layer 19. The tenth insulation layer 110 within the forty-third via V43 may be removed to expose a surface of the third anode connection electrode 143c located in the third source-drain metal layer 19.

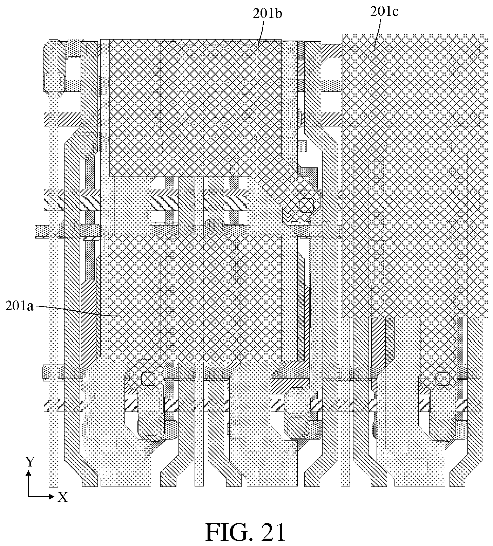

FIG. 21 is a schematic diagram of the display area after an anode layer is formed in FIG. 4. In some examples, as shown in FIG. 4 to FIG. 21, an anode layer 201 of the display area may include a plurality of anodes, for example, may include anodes 201a, 201b, and 201c. The anode 201a may be electrically connected with the third anode connection electrode 143a through the forty-first via V41. The anode 201b may be electrically connected with the third anode connection electrode 143b through the forty-second via V42, and the anode 201c may be electrically connected with the third anode connection electrode 143c through the forty-third via V43.

Examples of the bezel area of the display substrate of this embodiment will be described below.

In some examples, as shown in FIG. 1, the first bezel area B1 may include a first fan-out region B11, a bending region B12, a second fan-out region B13, a first circuit region B14, a third fan-out region B15, a first signal access region B16, and a second signal access region B17 disposed in sequence along the second direction Y away from the display area AA.

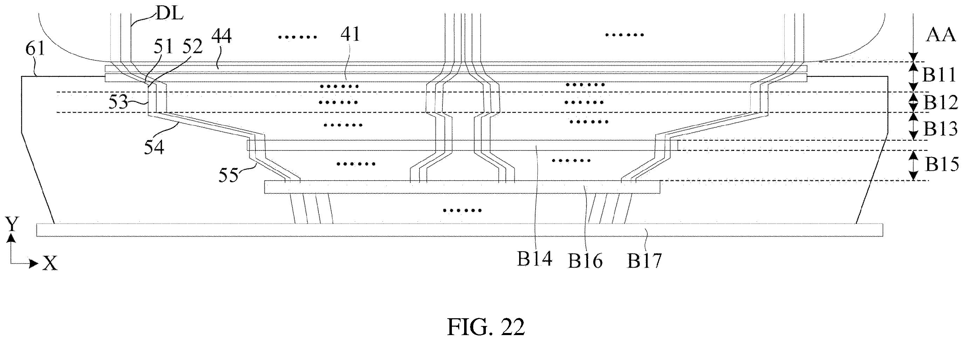

FIG. 22 is a partial trace diagram of a first bezel area according to at least one embodiment of the present disclosure. In some examples, as shown in FIG. 1 and FIG. 22, the first fan-out region B11 may be connected to the display area AA. The first fan-out region B11 may include a plurality of first data fan-out lines 51 and a plurality of second data fan-out lines 52. The plurality of first data fan-out lines 51 and the plurality of second data fan-out lines 52 may be electrically connected in one-to-one correspondence. The plurality of first data fan-out lines 51 may be electrically connected with a plurality of data lines DL of the display area AA, and a first data fan-out line 51 may be configured to be connected with a data line DL of the display area AA in a fan-out trace manner. For example, the plurality of data fan-out lines 51 may be electrically connected with the plurality of data lines DL in one-to-one correspondence. The first fan-out region B11 may further be provided with a first compensation unit 41 and a first anti-static circuit 44. For example, one end of a first data fan-out line 51 may be electrically connected with the first compensation unit 41 and the first anti-static circuit 44 and the other end of the first data fan-out line 51 may be electrically connected with a second data fan-out line 52. The first data fan-out line 51 and the second data fan-out line 52 may extend along a direction away from the display area AA. The second data fan-out line 52 may be located on a side of the first data fan-out line 51 away from the display area AA. In a direction perpendicular to the display substrate, the second data fan-out line 52 may be located on a side of the first data fan-out line 51 close to the base substrate.

In some examples, as shown in FIG. 1 and FIG. 22, the bending region B12 may be connected between the first fan-out region B11 and the second fan-out region B13. The bending region B12 may include a composite insulation layer provided with a groove, and may be configured to make the second fan-out region B13 to the second signal access region B17 be bent to a back of the display area AA. The bending region B12 may include a plurality of data bending lines 53. The plurality of data bending lines 53 may be electrically connected with the plurality of second data fan-out lines 52 in one-to-one correspondence. The second fan-out region B13 may be connected between the bending region B12 and the first circuit region B14. The second fan-out region B13 may include at least a plurality of third data fan-out lines 54 which are led out in a fan-out trace manner. The plurality of third data fan-out lines 54 may be electrically connected with the plurality of data bending lines 53 in one-to-one correspondence. The first circuit region B14 may include a second anti-static circuit and a test circuit. The second anti-static circuit may be configured to prevent electrostatic damages to the display substrate by eliminating static electricity. The test circuit may be configured to provide a data test signal to data lines DL of the display area AA. The third fan-out region B15 may be connected between the first circuit region B14 and the first signal access region B16. The third fan-out region B15 may include at least a plurality of fourth data fan-out lines 55 which are led out in a fan-out trace manner. The first signal access region B16 may be provided with an Integrated Circuit (IC). The second signal access region B17 may include a plurality of bonding pads, and the bonding pads may be configured to be bonded and connected to an external Flexible Printed Circuit (FPC). A connection trace may be disposed between the first signal access region B16 and the second signal access region B17.

In some examples, as shown in FIG. 22, the first bezel area B1 may be further provided with a ground connection line 61. The ground connection line 61 may be electrically connected with a ground terminal within the second signal access region B17. The ground connection line 61 may also be electrically connected with the first compensation unit 41 within the first fan-out region B11.

In some examples, as shown in FIG. 1, the third bezel area B2 may include a second circuit region, a power supply line region, a crack dam region, and a cutting region disposed sequentially along the first direction X away from the display area AA. The second circuit region may be connected to the display area AA and may at least include a gate drive circuit, and the gate drive circuit may be electrically connected with a first scan line, a second scan line, and a light emitting control line which are connected with a pixel circuit in the display area AA. The power supply line region may be connected to the second circuit region and may at least include a bezel power supply lead line. The bezel power supply lead line extends in a direction parallel to an edge of the display area and is connected with a cathode in the display area. The crack dam region is connected with the power supply line region and may at least include a plurality of cracks arranged on the composite insulation layer. The cutting region is connected with the crack dam region and may at least include a cutting groove disposed on the composite insulation layer, and the cutting groove is configured for respectively cutting along the cutting groove by a cutting equipment after all film layers of the display substrate are manufactured.

In some examples, as shown in FIG. 1, the first fan-out region B11 in the first bezel area B1 and the power supply line region in the second bezel area B2 may be provided with a first dam spacer DA1 and a second dam spacer DA2. The first dam spacer DA1 and the second dam spacer DA2 may extend in a direction parallel to an edge of the display area to form an annular structure surrounding the display area AA. The edge of the display area is an edge of the display area 100 close to the first bezel area B1 or the second bezel area B2. The second dam spacer DA2 may be located on a side of the first dam spacer DA1 away from the display area AA. The first dam spacer DA1 and the second dam spacer DA2 may be configured to block moisture entering the display area AA from a periphery of the display area AA.

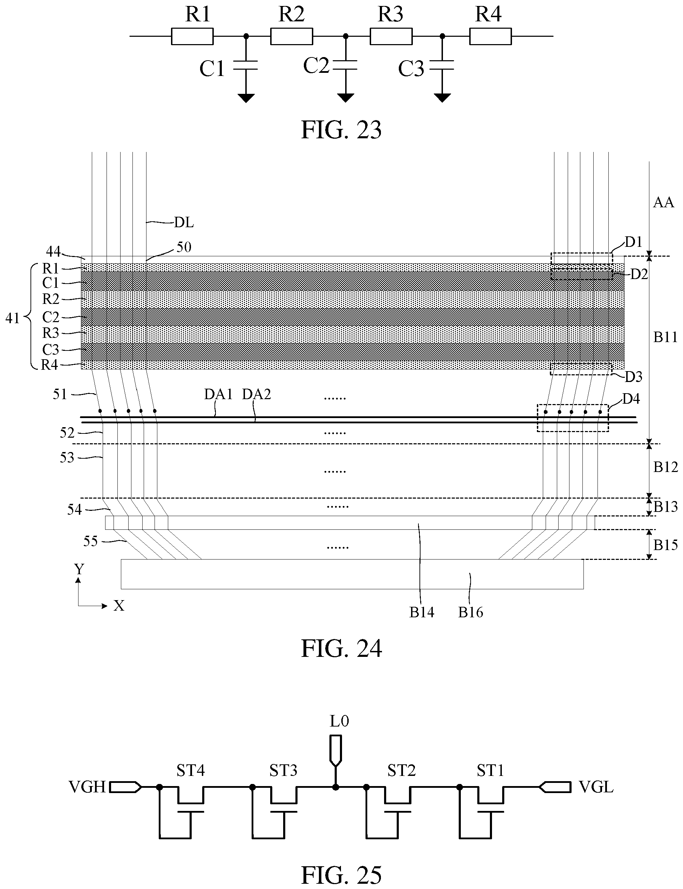

FIG. 23 is an equivalent circuit diagram of a first compensation unit according to at least one embodiment of the present disclosure. In some examples, as shown in FIG. 23, the first compensation unit may include first compensation resistors R1, R2, R3, R4 and first compensation capacitors C1, C2, C3. The first compensation resistors R1 to R4 may be electrically connected in series in turn. A first electrode of the first compensation capacitor C1 may be electrically connected between first compensation resistors R1 and R2, and a second electrode of the first compensation capacitor C1 may be grounded. A first electrode of the second compensation capacitor C2 may be electrically connected between first compensation resistors R2 and R3, and a second electrode of the second compensation capacitor C2 may be grounded. A first electrode of the third compensation capacitor C3 may be electrically connected between first compensation capacitors R3 and R4, and a second electrode may be grounded. A third-order model of resistance and capacitance is adopted for the first compensation unit of this example, which is beneficial to approximating an expected result and achieving a better compensation effect. In this embodiment, quantities of first compensation resistors and first compensation capacitors included in the first compensation unit are not limited. In some other examples, an N-order model may be adopted for the first compensation unit, and N may be greater than 3.

A first connection terminal of the first compensation unit of this example may be a first terminal of the first compensation resistor R1, and a second connection terminal of the first compensation unit may be a second terminal of the first compensation resistor R4. In some examples, the first compensation unit may be located in the first fan-out region, the first connection terminal of the first compensation unit may be electrically connected with a data line, and the second connection terminal may be electrically connected with a first data fan-out line. However, this embodiment is not limited thereto. In some other examples, the first compensation unit may be located in the second fan-out region or the third fan-out region. For example, a third data fan-out line of the second fan-out region may be divided into two sub-data fan-out lines, and the first compensation unit may be connected between the two sub-data fan-out lines. For example, the first connection terminal of the first compensation unit may be electrically connected with one sub-data fan-out line and the second connection terminal of the first compensation unit may be electrically connected with the other sub-data fan-out line.

In some examples, as shown in FIG. 23, capacitance values of the first compensation capacitors C1, C2, and C3 may be the same, for example, may all be $C/3$. Resistance values of first compensation resistors R1 and R4 may be the same, for example, may both be $R/6$, and resistance values of first compensation resistors R2 and R3 may be the same, for example, may both be $R/3$. Among them, R may be a preset resistance parameter required for compensation, and C may be a preset capacitance parameter required for compensation.

FIG. 24 is a partial schematic diagram of the first bezel area according to at least one embodiment of the present disclosure. In some examples, as shown in FIG. 24, the first compensation unit 41 may be located in the first fan-out region B11. A data line DL of the display area AA may extend to the first fan-out region B11 and be electrically connected with a first data connection line 50 within the first fan-out region B 11. One end of the first data connection line 50 may be electrically connected with the data line DL, and the other end of the first data connection line 50 may be electrically connected with the first anti-static circuit 44 and the first compensation unit 41 in turn, and electrically connected with a first data fan-out line 51 through the first compensation unit 41. The first data fan-out line 51 is electrically connected with a second data fan-out line 52. A connection position of the first data fan-out line 51 and the second data fan-out line 52 (such as a black dot position in FIG. 24) may be located on a side of the first dam spacer DA1 close to the display area AA.

FIG. 25 is an equivalent circuit diagram of the first anti-static circuit according to at least one embodiment of the present disclosure. In some examples, as shown in FIG. 25, the first anti-static circuit may include a first release transistor ST1 to a fourth release transistor ST4. A first electrode of the first release transistor ST1 is electrically connected with a fourth power supply line VGL. A gate and a second electrode of the first release transistor ST1 are electrically connected with a first electrode of the second release transistor ST2, a gate and a second electrode of the second release transistor ST2 are electrically connected with a signal input terminal L0 of the first anti-static circuit. A first electrode of the third release transistor ST3 is electrically connected with the signal input terminal L0 of the first anti-static circuit, a gate and a second electrode of the third release transistor ST3 are electrically connected with a first electrode of the fourth release transistor ST4. A gate and a second electrode of the fourth release transistor ST4 are electrically connected with a third power supply line VGH. A third voltage signal provided by the third power supply line VGH may be greater than a fourth voltage signal provided by the fourth power supply line VGL. The signal input terminal L0 may be electrically connected with a trace (for example, a first data connection line) for transmitting a data signal to prevent a damage caused by discharge breakdown due to accumulation of static electricity in the trace for transmitting the data signal, so as to release the accumulated static electricity in the trace and achieve protection of the trace. However, this embodiment is not limited thereto. In another example, the first anti-static circuit may include two release transistors, wherein one electrode of each release transistor is connected with its own gate, thereby forming an equivalent diode connection. While a trace to be protected is connected between two "diodes", and other two terminals of the two "diodes" are respectively connected with the third power supply line VGH and the fourth power supply line VGL. Therefore, when an instantaneous high voltage (e.g., 100 V) appears in a signal line due to accumulation of positive charges, one of the "diodes" is turned on to release the positive charges in the trace, and when an instantaneous low voltage (e.g., -100 V) appears in the trace due to accumulation of negative charges, the other of the "diodes" is turned on to release the negative charges in a signal line.

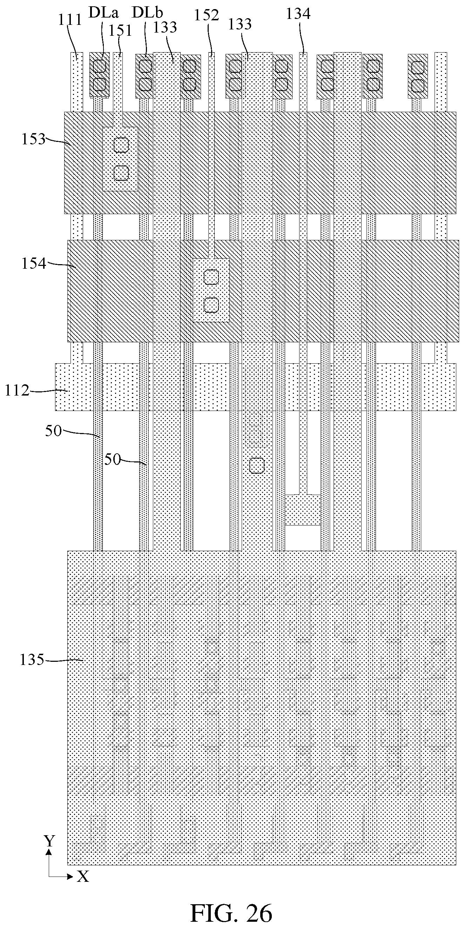

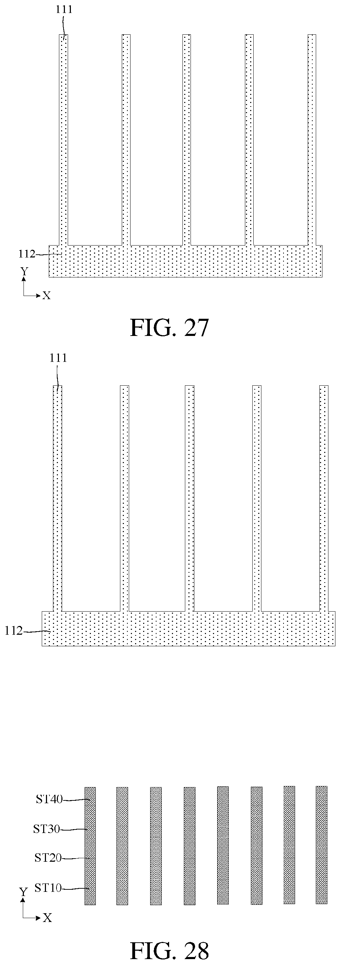

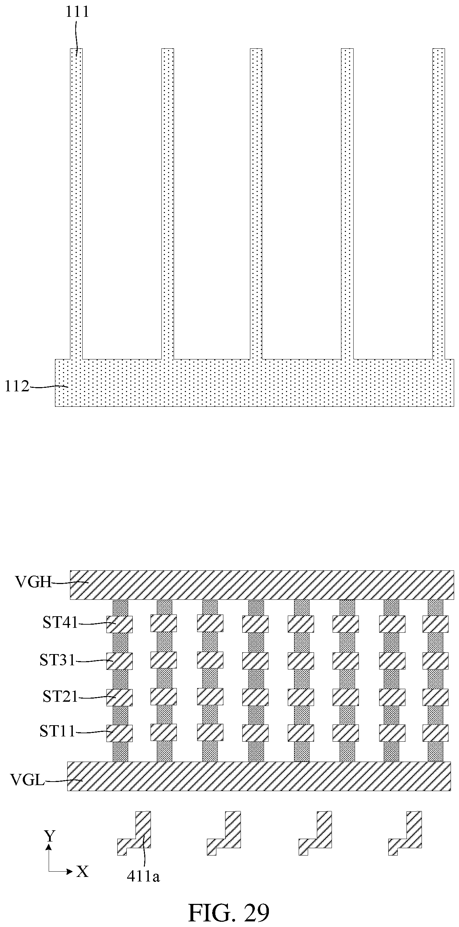

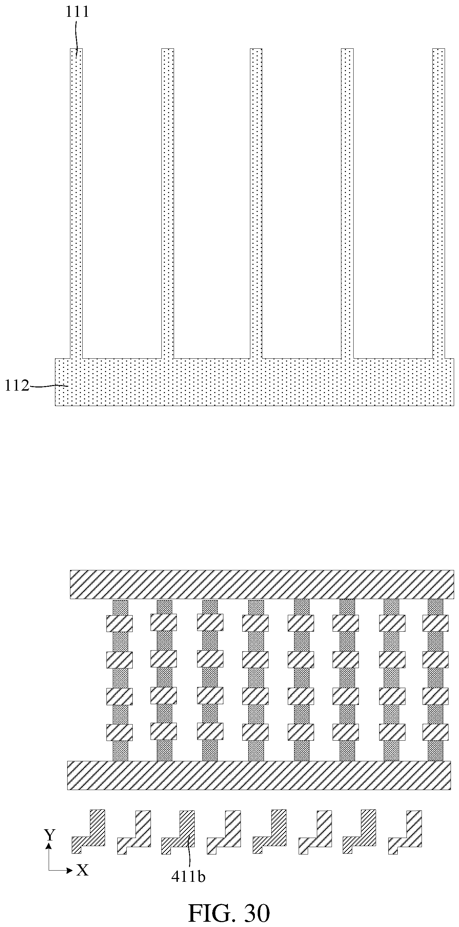

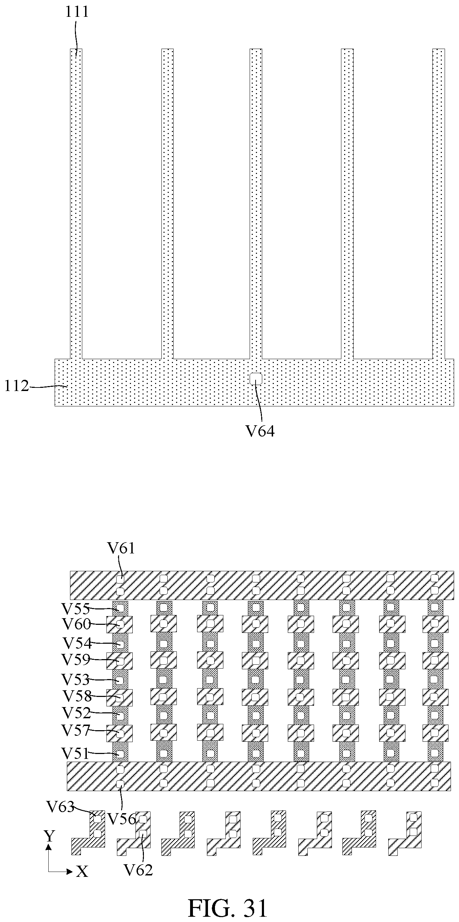

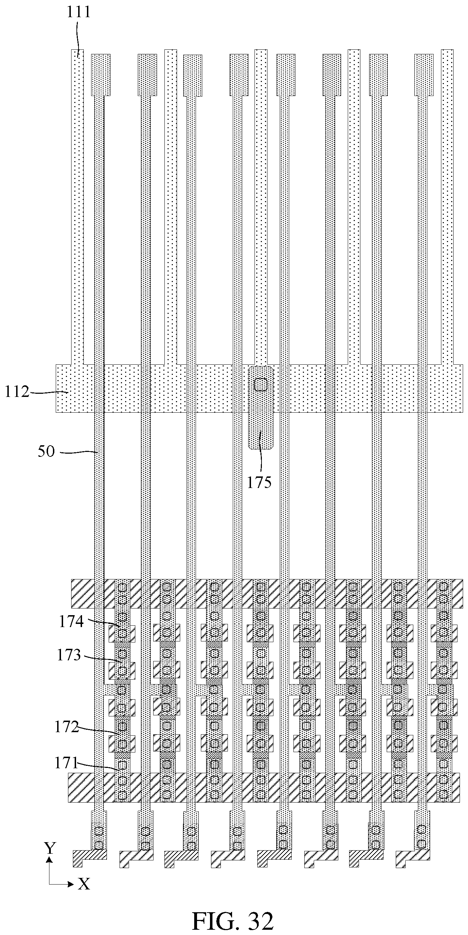

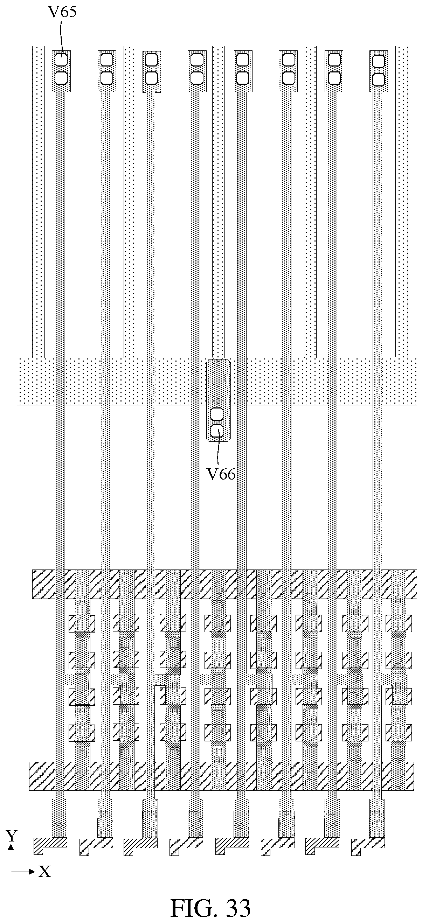

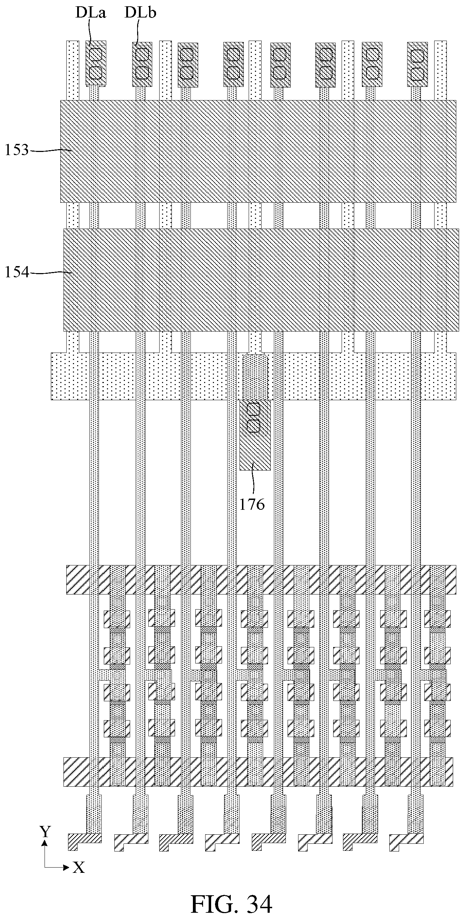

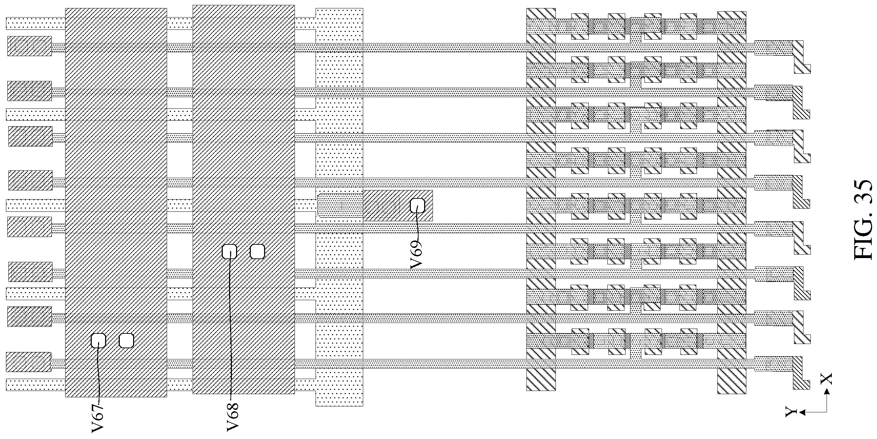

FIG. 26 is a partial enlarged schematic diagram of a region D1 in FIG. 24. FIG. 27 is a schematic diagram of a light shielding layer in FIG. 26. FIG. 28 is a partial schematic diagram of a first bezel area after a first semiconductor layer is formed in FIG. 26. FIG. 29 is a partial schematic diagram of a first bezel area after a first gate metal layer is formed in FIG. 26. FIG. 30 is a partial schematic diagram of a first bezel area after a second gate metal layer is formed in FIG. 26. FIG. 31 is a partial schematic diagram of a first bezel area after a sixth insulation layer is formed in FIG. 26. FIG. 32 is a partial schematic diagram of a first bezel area after a first source-drain metal layer is formed in FIG. 26. FIG. 33 is a partial schematic diagram of a first bezel area after an eighth insulation layer is formed in FIG. 26. FIG. 34 is a partial schematic diagram of a first bezel area after a second source-drain metal layer is formed in FIG. 26. FIG. 35 is a partial schematic diagram of a first bezel area after a ninth insulation layer is formed in FIG. 26. FIG. 26 is a partial schematic diagram of a first bezel area after a third source-drain metal layer is formed. In FIG. 26 to FIG. 35, eight data lines and eight first data connection lines are taken as examples for illustration. Among them, the first compensation resistor R1 may be located on a side of the first anti-static circuit 44 away from the display area AA.

In some examples, as shown in FIG. 26 and FIG. 27, a light shielding layer of the first fan-out region may include a bezel light shielding trace 112. The bezel light shielding trace 112 may extend in the first direction X. A plurality of light shielding traces 111 of the display area may extend to the first fan-out region B11 in the second direction Y and are electrically connected with the bezel light shielding trace 112. For example, a light shielding trace 111 and the bezel light shielding trace 112 may be of and integral structure.

In some examples, as shown in FIG. 26 to FIG. 28, a first semiconductor layer of the first fan-out region may include active layers of a plurality of release transistors of a plurality of first anti-static circuits (for example, may include an active layer ST10 of a first release transistor ST1, an active layer ST20 of a second release transistor ST2, an active layer ST30 of a third release transistor ST3, and an active layer ST40 of a fourth release transistor ST4). Active layers of four release transistors of one first anti-static circuit may be of an integral structure.

In some examples, as shown in FIG. 26 to FIG. 29, a first gate metal layer of the first fan-out region may include gates of a plurality of release transistors of a plurality of first anti-static circuits (for example, may include a gate ST11 of the first release transistor ST1, a gate ST21 of the second release transistor ST2, a gate ST31 of the third release transistor ST3, and a gate ST41 of the fourth release transistor ST4), a third power supply line VGH, a fourth power supply line VGL, and a resistor trace 411a of a first compensation resistor R1. The third power supply line VGH and the fourth power supply line VGL may both extend in the first direction X. As shown in FIG. 30, a second gate metal layer may include a resistor trace 411b of another first compensation resistor R1.

In some examples, as shown in FIG. 31, the sixth insulation layer of the first fan-out region may be provided with a plurality of vias, which may include a fifty-first via V51 to a sixty-fourth via V64 for example. The sixth insulation layer to the second insulation layer within the fifty-first via V51 to the fifty-fifth via V55 may be removed to expose a surface of the first semiconductor layer. The sixth insulation layer to the third insulation layer within the fifty-sixth via V56 to the sixty-second via V62 may be removed to expose a surface of the first gate metal layer. The sixth insulation layer to the fourth insulation layer within the sixty-third via V63 may be removed to expose a surface of the second gate metal layer. The sixth insulation layer to the first insulation layer within the sixty-fourth via V64 may be removed to expose a surface of the bezel light shielding trace 112 located in the light shielding layer.

In some examples, as shown in FIG. 26 to FIG. 32, the first source-drain metal layer of the first fan-out region may include a plurality of first data connection lines 50, and a plurality of connection electrodes (e.g. including an eleventh connection electrode 171 to a fifteenth connection electrode 175). One first data connection line 50 may be electrically connected with one doped region of the active layer ST20 of the second release transistor ST2 through the fifty-third via V53, may also be electrically connected with the gate ST21 of the second release transistor ST2 through the fifty-eighth via V58, and may also be electrically connected with the resistor trace 411b of the first compensation resistor R1 through two sixty-third vias V63 arranged vertically. Another first data connection line 50 may be electrically connected with another first anti-static circuit, and may also be electrically connected with the resistor trace 411a of another first compensation resistor R1 through two sixty-second vias V62 arranged vertically. The eleventh connection electrode 171 may be electrically connected with the fourth power supply line VGL through two fifty-sixth vias V56 arranged vertically, and may also be electrically connected with one doped region of the active layer ST10 of the first release transistor ST1 through the fifty-first via V51. The twelfth connection electrode 172 may be electrically connected with the gate ST11 of the first release transistor ST1 through the fifty-seventh via V57, and may also be electrically connected with another doped region of the active layer ST10 of the first release transistor ST1 through the fifty-second via V52. The thirteenth connection electrode 173 may be electrically connected with the gate ST31 of the third release transistor ST3 through the fifty-ninth via V59, and may also be electrically connected with one doped region of the active layer ST30 of the third release transistor ST3 through the fifty-fourth via V54. The fourteenth connection electrode 174 may be electrically connected with the gate ST41 of the fourth release transistor ST4 through the sixtieth via V60, may also be electrically connected with one doped region of the active layer ST40 of the fourth release transistor ST4 through the fifty-fifth via V55, and may also be electrically connected with the third power supply line VGH through two sixty-first vias V61 arranged vertically. The fifteenth connection electrode 175 may be electrically connected with the bezel light shielding trace 112 through the sixty-fourth via V64.

In the present disclosure, being arranged vertically may mean that being arranged in sequence along the second direction Y.

In some examples, as shown in FIG. 26 to FIG. 33, the eighth insulation layer of the first fan-out region may be provided with a plurality of vias, which may include a sixty-fifth via V65 and a sixty-sixth via V66 for example. The eighth insulation layer and the seventh insulation layer within the sixty-fifth via V65 may be removed to expose a surface of the first data connection line 50. The eighth insulation layer and the seventh insulation layer within the sixty-sixth via V66 may be removed to expose a surface of the fifteenth connection electrode 175.

In some examples, as shown in FIG. 26 to FIG. 34, the second source-drain metal layer of the first fan-out region may include a first bezel initial line 153, a second bezel initial line 154, a sixteenth connection electrode 176, and data lines (e.g. data lines DLa and DLb) extending to the first fan-out region. The first bezel initial line 153 and the second bezel initial line 154 may both extend in the first direction X. The second bezel initial line 154 may be located on a side of the first bezel initial line 153 away from the display area. Orthographic projections of the first bezel initial line 153 and the second bezel initial line 154 on the base substrate may be located on a side of an orthographic projection of the bezel light shielding trace 112 on the base substrate close to the display area. The data line DLa extending to the first fan-out region may be electrically connected with one first data connection line 50 through two sixty-fifth vias V65 arranged vertically, and the data line DLb extending to the first fan-out region may be electrically connected with another first data connection line 50 through another two sixty-fifth vias V65 arranged vertically. The sixteenth connection electrode 176 may be electrically connected with the fifteenth connection electrode 175 through two sixty-sixth vias V66 arranged vertically.

In some examples, as shown in FIG. 26 to FIG. 35, the ninth insulation layer of the first fan-out region may be provided with a plurality of vias which may include a sixty-seventh via V67 to a sixty-ninth via V69 for example. The ninth insulation layer within the sixty-seventh via V67 may be removed to expose a surface of the first bezel initial line 153. The ninth insulation layer within the sixty-eighth via V68 may be removed to expose a surface of the second bezel initial line 154. The ninth insulation layer within the sixty-ninth via V69 may be removed to expose a surface of the sixteenth connection electrode 176.

In some examples, as shown in FIG. 26, the third source-drain metal layer of the first fan-out region may include at least a first initial connection line 151, a second initial connection line 152, a third power supply connection line 133, a fourth power supply connection line 134, and a first bezel power supply line 135. The first initial connection line 151, the second initial connection line 152, the third power supply connection line 133, and the fourth power supply connection line 134 may extend from the display area to the first fan-out region in the second direction Y. The first initial connection line 151 may be electrically connected with the first bezel initial line 153 through two sixty-seventh vias V67 arranged vertically. The second initial connection line 152 may be electrically connected with the second bezel initial line 154 through two sixty-eighth vias V68 arranged vertically. At least one third power supply connection line 133 of a plurality of third power supply connection lines 133 may be electrically connected with the sixteenth connection electrode 176 through the sixty-ninth via V69, thereby being electrically connected with the bezel light shielding trace 122 through the sixteenth connection electrode 176 and the fifteenth connection electrode 175, so that the bezel light shielding trace 122 and the light shielding trace 111 may transmit a first voltage signal. The first bezel power supply line 135 may extend in the first direction X. An orthographic projection of the first bezel power supply line 135 on the base substrate may be overlapped with an orthographic projection of a plurality of first anti-static circuits on the base substrate. The first bezel power supply line 135 and the plurality of third power supply connection lines 133 may be of an integral structure and be configured to transmit a first voltage signal. The fourth power supply connection line 134 may be configured to transmit a second voltage signal. For example, a tenth insulation layer and an anode layer may be sequentially disposed on a side of the third source-drain metal layer away from the base substrate, and the fourth power supply connection line 134 may be electrically connected with a power supply connection electrode located in the anode layer through a via provided in the tenth insulation layer, and electrically connected with a second power supply line through the power supply connection electrode. For example, the second power supply line may be located in the third source-drain metal layer and on a side of the first bezel power supply line away from the display area.

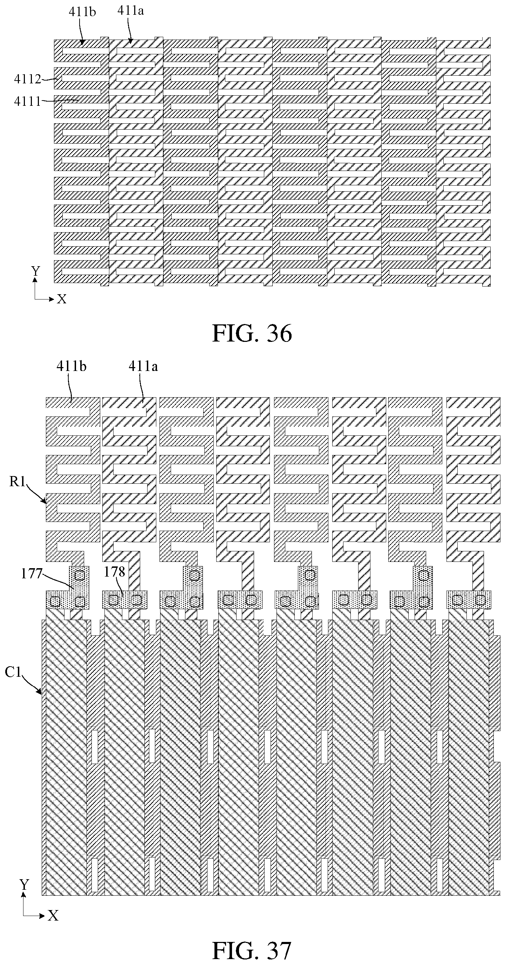

FIG. 36 is a partial schematic diagram of a first compensation resistor according to at least one embodiment of the present disclosure. In FIG. 36, a plurality of first compensation resistors R1 are taken as an example for illustration. In some examples, as shown in FIG. 36, a first compensation resistor may include a resistor trace. In the first fan-out region, a plurality of first compensation resistors electrically connected with a plurality of first data connection lines may be arranged in sequence along the first direction X. Resistor traces of adjacent first compensation resistors arranged along the first direction X may be located in different conductive layers, and orthographic projections of the resistor traces on the base substrate may not be overlapped with each other. For example, one first compensation resistor R1 may include a resistor trace 411a located in a first gate metal layer and an adjacent first compensation resistor R1 may include a resistor trace 411b located in a second gate metal layer. In this example, resistor traces of adjacent first compensation resistors are arranged in the first gate metal layer and the second gate metal layer, so that occupied space may be saved, and the first gate metal layer and the second gate metal layer are manufactured by using a metal material with a high resistivity, which is conducive to increasing a compensation resistance.

In some examples, as shown in FIG. 36, an orthographic projection of the resistor trace 411a or 411b of the first compensation resistor R1 on the base substrate may be a serpentine trace, which is conducive to increasing a compensation resistance. For example, the resistor trace 411b of the first compensation resistor R1 may include a plurality of first line segments 4111 and a plurality of second line segments 4112. Extension directions of the plurality of first line segments 4111 may be substantially parallel, for example, all extend in the first direction X. Extension directions of the plurality of second line segments 4112 may be substantially parallel, for example, all extend in the second direction Y. A first line segment 4111 and a second line segment 4112 may be connected in series. Two adjacent first line segments 4111 may be connected through one second line segment 4112. Two second line segments 4112 connected with both ends of one first line segment 4111 are located on two sides of the first line segment 4111 along the first direction X and located on two sides of the first line segment 4111 along the second direction Y. The first line segments 4111 and the second line segments 4112 may be straight line segments. In some other examples, the second line segments 4112 may be arc segments; or, the first line segments 4111 may be arc segments, or the first line segments 4111 and the second line segments 4112 may both be arc segments. However, this embodiment is not limited thereto. In some other examples, a resistor trace may be a linear trace. In this example, a length and a shape of a resistor trace of the first compensation resistor may be determined according to a magnitude of a resistor to be compensated.

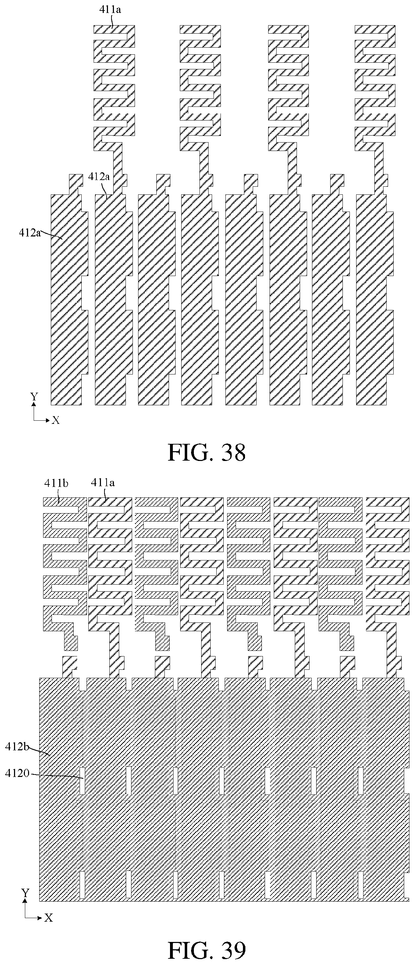

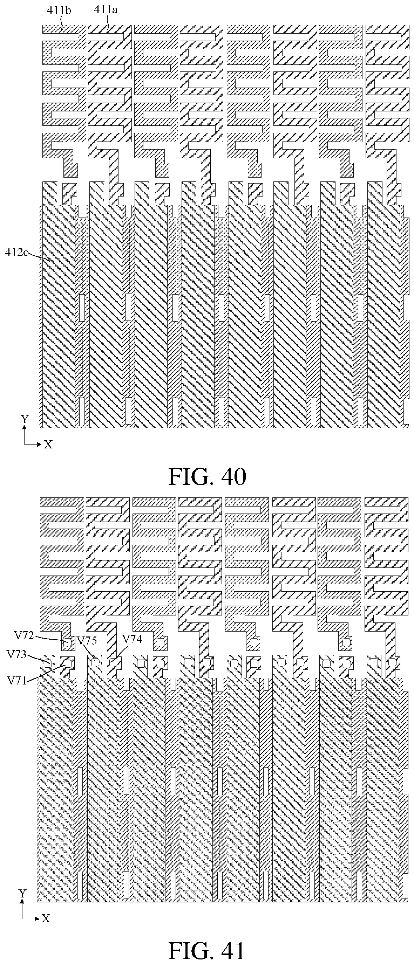

FIG. 37 is a partial enlarged schematic diagram of a region D2 in FIG. 24. FIG. 37 is a schematic diagram of a connection position of a first compensation resistor R1 and a first compensation capacitor C1. FIG. 38 is a partial schematic diagram of a first fan-out region after a first gate metal layer is formed in FIG. 37. FIG. 39 is a partial schematic diagram of a first fan-out region after a second gate metal layer is formed in FIG. 37. FIG. 40 is a partial schematic diagram of a first fan-out region after a third gate metal layer is formed in FIG. 37. FIG. 41 is a partial schematic diagram of a first fan-out region after a sixth insulation layer is formed in FIG. 37. FIG. 37 is a partial schematic diagram of a first fan-out region after a first source-drain metal layer is formed.

In some examples, as shown in FIG. 37, a plurality of first compensation capacitors C1 respectively electrically connected with a plurality of first compensation resistors R1 may be sequentially arranged along the first direction X. As shown in FIG. 38, the first gate metal layer of the first fan-out region may further include a first electrode plate 412a of a first compensation capacitor C1. When a resistor trace of a first compensation resistor is located in the first gate metal layer, the first compensation resistor and the first electrode plate of the first compensation capacitor to which the first compensation resistor is electrically connected may be of an integral structure. For example, the resistor trace 411a of the first compensation resistor R1 and the first electrode plate 412a of the first compensation capacitor C1 to which the first compensation resistor R1 is electrically connected may be of an integral structure.

In some examples, as shown in FIG. 39, the second gate metal layer of the first fan-out region may further include second electrode plate 412b of the first compensation capacitor C1. An orthographic projection of the second electrode plate 412b of the first compensation capacitor C1 on the base substrate may be overlapped with an orthographic projection of the first electrode plate 412a on the base substrate. In some examples, second electrode plates 412b of the plurality of first compensation capacitors C1 may be of an integral structure, and a first opening 4120 may be provided at a connection position of adjacent second electrode plates 412b, and an orthographic projection of the first opening 4120 on the base substrate may not be overlapped with an orthographic projection of the first electrode plate 412a on the base substrate. By providing the first opening 4120 on integrally formed second electrode plates, defects generated in a large-area metal manufacturing process may be avoided.

In some examples, as shown in FIG. 40, the third gate metal layer of the first fan-out region may include a third electrode plate 412c of the first compensation capacitor C1. An orthographic projection of the third electrode plate 412c of the first compensation capacitor C1 on the base substrate may be overlapped with each of the orthographic projection of the second electrode plate 412b on the base substrate and the orthographic projection of the first electrode plate 412a on the base substrate. The orthographic projection of the third electrode plate 412c on the base substrate may not be overlapped with the orthographic projection of the first opening 4120 on the base substrate.

In some examples, as shown in FIG. 41, the sixth insulation layer of the first fan-out region may further provided with a plurality of vias, which may include a seventy-first via V71 to a seventy-fifth via V75 for example. The sixth insulation layer to the third insulation layer within the seventy-first via V71 may be removed to expose a surface of the first electrode plate 412a disposed independently, and the sixth insulation layer to the third insulation layer within the seventy-fourth via V74 may be removed to expose a surface of the first electrode plate 412a having an integral structure with the resistor trace 411a of the first compensation resistor R1. The sixth insulation layer to the fourth insulation layer within the seventy-second via V72 may be removed to expose a surface of the resistor trace 411b of the first compensation resistor R1. The sixth insulation layer within the seventy-third via V73 and the seventeenth-fifth via V75 may be removed to expose a surface of the third electrode plate 412c of the first compensation capacitor C1.

In some examples, as shown in FIG. 37, the first source-drain metal layer of the first fan-out region may further include a seventeenth connection electrode 177 and an eighteenth connection electrode 178. The seventeenth connection electrode 177 may be electrically connected with the resistor trace 411b of the first compensation resistor R1 located in the second gate metal layer through the seventy-second via V72, may also be electrically connected with the first electrode plate 412a of the first compensation capacitor C1 disposed separately through the seventy-first via V71, and may also be electrically connected with the third electrode plate 412c through the seventy-third via V73. The eighteenth connection electrode 178 may be electrically connected with the resistor trace 411a of the first compensation resistor R1 and the first electrode plate 412a of the first compensation capacitor C1 through the seventy-fourth via V74, and may also be electrically connected with the third electrode plate 412c of the first compensation capacitor C1 through the seventy-fifth via V75. In this example, a first electrode plate 412a and a third electrode plate 412c of one first compensation capacitor C1 may be electrically connected to form a first electrode of the first compensation capacitor C1 and the first electrode is electrically connected with the first compensation resistor R1, and a second electrode plate 412b of one first compensation capacitor C1 may serve as a second electrode and be grounded. For example, the second electrode plate 412b of the first compensation capacitor C1 may be electrically connected with a ground terminal of a second signal access region (a second signal access region B17 shown in FIG. 22) through a ground connection line (a ground connection line 61 shown in FIG. 22).

In this example, three electrode plates of the first compensation capacitor are arranged in the first gate metal layer to the third gate metal layer, and an insulation layer disposed between adjacent metal layers in the first gate metal layer to the third gate metal layer is relatively thin, so that performance of a compensation capacitor may be ensured. Furthermore, second electrode plates of a plurality of second compensation capacitors may be of an integral structure and form a mesh structure, thereby simplifying a manufacturing process and minimizing occupied space.

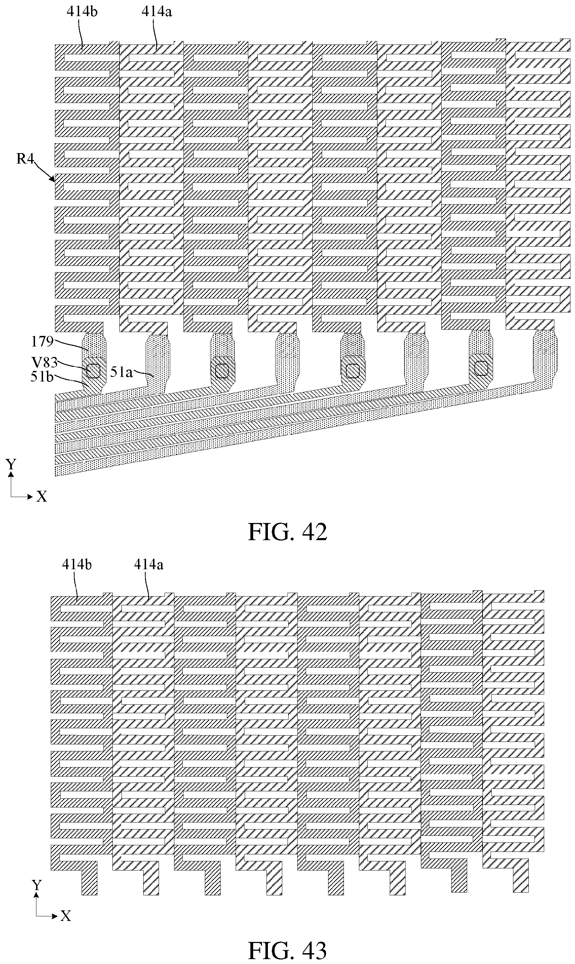

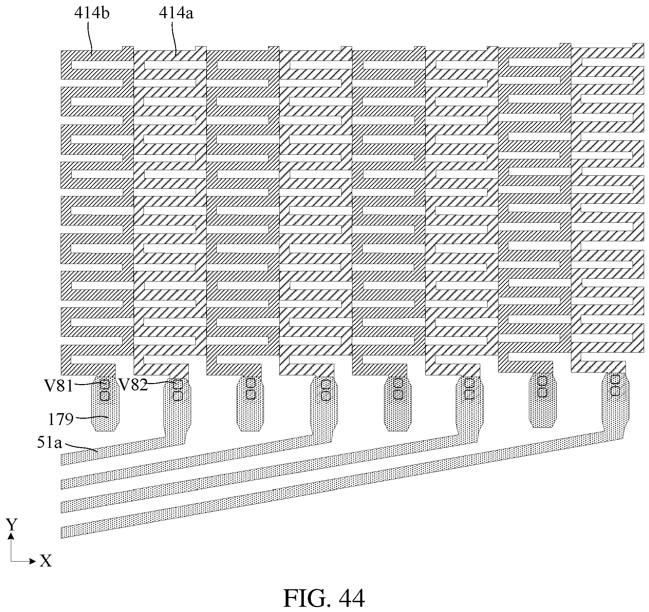

FIG. 42 is a partial enlarged schematic diagram of a region D3 in FIG. 24. FIG. 42 is a schematic diagram showing a connection position between a first compensation resistor R4 and a first data fan-out line 51. FIG. 43 is a partial schematic diagram of a first fan-out region after a second gate metal layer is formed in FIG. 42. FIG. 44 is a partial schematic diagram of a first fan-out region after a first source-drain metal layer is formed in FIG. 42. FIG. 42 is a partial schematic diagram of a first fan-out region after a second source-drain metal layer is formed.

In some examples, as shown in FIG. 42 to FIG. 44, a plurality of first data fan-out lines may include a plurality of first type first data fan-out lines 51a and a plurality of second type first data fan-out lines 51b. The first type first data fan-out lines 51a and the second type first data fan-out lines 51b may be arranged at intervals along the first direction X. A first type first data fan-out line 51a may be located on a side of a second type first data fan-out line 51b close to the base substrate. For example, the first type first data fan-out lines 51a may be located in the first source-drain metal layer and the second type first data fan-out lines 51b may be located in the second source-drain metal layer. An orthographic projection of the first type first data fan-out lines 51a on the base substrate may not be overlapped with an orthographic projection of the second type first data fan-out lines 51b on the base substrate.

In some examples, as shown in FIG. 42 to FIG. 44, a first compensation resistor R4 may include a resistor trace 414a or 414b. The resistor trace 414a may be located in the first gate metal layer and the resistor trace 414b may be located in the second gate metal layer. A resistor trace 414a of one first compensation resistor R4 may be electrically connected with a first type first data fan-out line 51a through two eighty-second vias V82 arranged vertically. A resistor trace 414b of another first compensation resistor R4 may be electrically connected with the nineteenth connection electrode 179 through two eighty-first vias V81 arranged vertically. The nineteenth connection electrode 179 may be disposed in a same layer with the first type first data fan-out line 51a. The nineteenth connection electrode 179 may be electrically connected with the second type first data fan-out line 51b through the eighty-third via V83.

In this example, structures of first compensation resistors R2 and R3 may be referred to structures of first compensation resistors R1 and R4, structures of first compensation capacitors C2 and C3 may be referred to a structure of the first compensation capacitor C1, and a connection relationship between the first compensation resistors and the first compensation capacitors may be referred to a connection relationship between the first compensation resistors R1 and the first compensation capacitors C1, which will not be repeated in this embodiment.

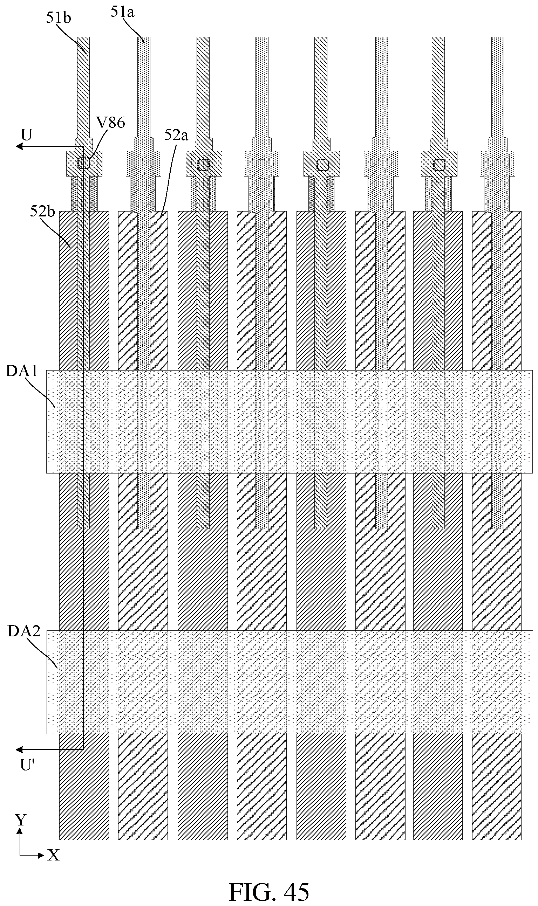

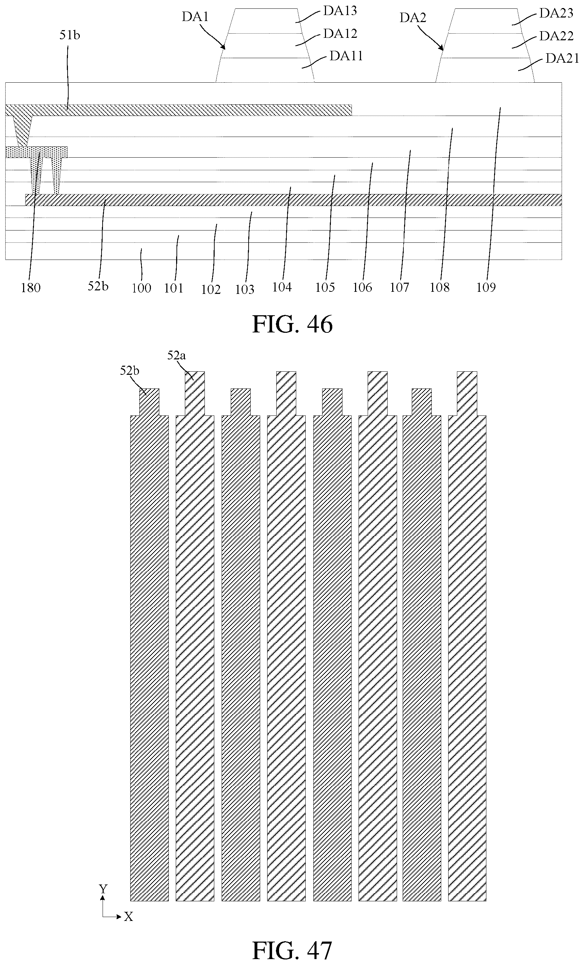

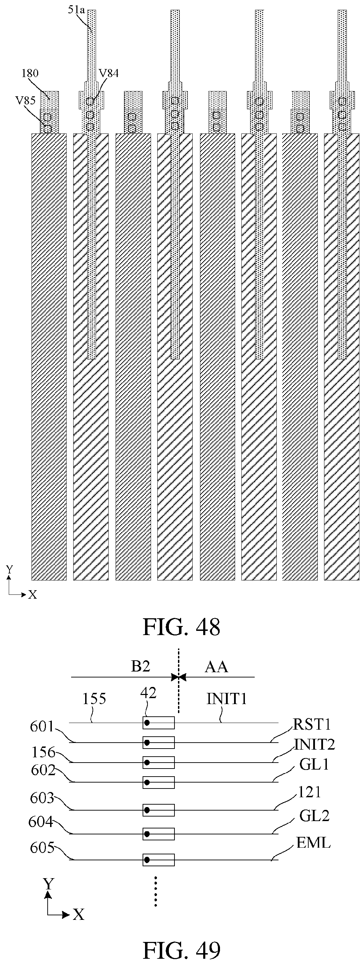

FIG. 45 is a partial enlarged schematic diagram of a region D4 in FIG. 24. FIG. 45 is a schematic diagram showing a connection between a first data fan-out line 51 and a second data fan-out line 52 in the first fan-out region. FIG. 46 is a partial sectional view along a U-U' direction in FIG. 45. FIG. 47 is a partial schematic diagram of a first fan-out region after a second gate metal layer is formed in FIG. 45. FIG. 48 is a partial schematic diagram of a first fan-out region after a first source-drain metal layer is formed in FIG. 45.

In some examples, as shown in FIG. 45 to FIG. 47, in the first fan-out region, a plurality of first data fan-out lines are electrically connected with a plurality of second data fan-out lines in one-to-one correspondence. The plurality of first data fan-out lines may include a plurality of first type first data fan-out lines 51a and a plurality of second type first data fan-out lines 51b. The plurality of second data fan-out lines may include a plurality of first type second data fan-out lines 52a and a plurality of second type second data fan-out lines 52b. The first type second data fan-out lines 52a and the second type second data fan-out lines 52b may be arranged at intervals along the first direction X. A first type second data fan-out line 52a may be located on a side of a second type second data fan-out line 52b close to the base substrate, and an orthographic projection of the first type second data fan-out line 52a on the base substrate may not be overlapped with an orthographic projection of the second type second data fan-out line 52b on the base substrate. For example, the first type second data fan-out lines 52a may be located in the first gate metal layer and the second type second data fan-out lines52b may be located in the second gate metal layer. In some other examples, a second data fan-out line may be located in the third gate metal layer.

In some examples, as shown in FIG. 45 to FIG. 47, the first type first data fan-out line 51a located in the first source-drain metal layer may be electrically connected with the first type second data fan-out line 52a located in the first gate metal layer through three eighty-fourth vias V84 arranged vertically. The twentieth connection electrode 180 located in the first source-drain metal layer may be electrically connected with the second type second data fan-out line 52b located in the second gate metal layer through two eighty-fifth vias V85 arranged vertically. The second type first data fan-out line 51b located in the second source-drain metal layer may be electrically connected with the twentieth connection electrode 180 through the eighty-sixth via V86, thereby achieving an electrical connection between the second type second data fan-out line 52b and the second type first data fan-out line 51b. A connection method of this example may avoid opening too deep vias. However, this embodiment is not limited thereto. In some other examples, the first type first data fan-out lines may be electrically connected (e.g., through connection electrodes) with the second type second data fan-out lines, and the second type first data fan-out lines may be electrically connected (e.g., through connection electrodes) with the first type second data fan-out lines.

In some examples, a resistivity of a material of the first data fan-out lines may be less than a resistivity of a material of the second data fan-out lines, thereby reducing load of data lines. For example, a Titanium (Ti)/Aluminum (Al)/Ti laminated structure may be used for the first data fan-out lines, and the material of the second data fan-out lines may be Molybdenum (Mo).

In some examples, as shown in FIG. 45 to FIG. 47, a connection position of the first type first data fan-out line 51a and the first type second data fan-out line 52a may be located on a side of the first dam spacer DA1 close to the display area. A connection position of the second type first data fan-out line 51b and the second type second data fan-out line 52b may be located on a side of the first dam spacer DA1 close to the display area. Orthographic projections of the first type first data fan-out line 51a and the second type first data fan-out line 51b on the base substrate may be overlapped with an orthographic projection of the first dam spacer DA1 on the base substrate, and may not be overlapped with an orthographic projection of the second dam spacer DA2 on the base substrate.

In some examples, as shown in FIG. 46, the first dam spacer DA1 may include a first dam foundation DA11, a third dam foundation DA12, and a fifth dam foundation DA13 that are sequentially stacked. The second dam spacer DA2 may include a second dam foundation DA21, a fourth dam foundation DA22, and a sixth dam foundation DA23 stacked in sequence. The first dam foundation DA11 and the second dam foundation DA21 may be disposed on the ninth insulation layer 109, and the first insulation layer 101 to the eighth insulation layer 108a may be provided on a side of the ninth insulation layer 109 close to the base substrate 100. The first dam foundation DA11 and the second dam foundation DA21 may be disposed in a same layer with the tenth insulation layer. The third dam foundation DA12 and the fourth dam foundation DA22 may be disposed in a same layer with a pixel definition layer. The fifth dam foundation DA13 and the sixth dam foundation DA23 may be disposed in a same layer with a post spacer layer. In some examples, heights of the first dam spacer DA1 and the second dam spacer DA2 may be substantially the same. In some other examples, the heights of the first dam spacer DA1 and the second dam spacer DA2 may be different, for example, a height of the second dam spacer DA2 may be greater than a height of the first dam spacer DA1. For example, the eighth insulation layer 108 or the ninth insulation layer 109 on a side of the first dam spacer DA1 close to the base substrate may be removed. However, this embodiment is not limited thereto.

In this example, the first data fan-out lines are disposed in the first source-drain metal layer and the second source-drain metal layer, and resistivities of metal materials of the first source-drain metal layer and the second source-drain metal layer are lower than resistivities of metal materials of the first gate metal layer and the second gate metal layer, so that a resistivity of the first data fan-out lines may be reduced, thereby reducing load of data lines. In this example, the first data fan-out lines and the second data fan-out lines are connected on a side of the first dam spacer close to the display area, so that it may be avoided that moisture is introduced into the display area through the first source-drain metal layer and the second source-drain metal layer, resulting in corrosion of a light emitting element.

In some examples, as shown in FIG. 24, a plurality of second data fan-out lines 52 may be electrically connected with a plurality of data bending lines 53 within the bending region B12. The plurality of data bending lines 53 may be located in the second source-drain metal layer. The plurality of data bending lines 53 may be electrically connected with a plurality of third data fan lines 54 in the second fan-out region B13. The plurality of third data fan-out lines 54 may include a plurality of first type third data fan-out lines and a plurality of second type third data fan-out lines, the first type third data fan-out lines and the second type third data fan-out lines may be arranged at intervals, and an orthographic projection of the first type third data fan-out lines on the base substrate may not be overlapped with an orthographic projection of the second type third data fan-out lines on the base substrate. For example, the first type third data fan-out lines may be located in the first source-drain metal layer, and the second type third data fan-out lines may be located in the second source-drain metal layer to reduce a resistivity of the third data fan-out lines, thereby reducing load of data lines. In some other examples, a plurality of fourth data fan-out lines 55 located in the third fan-out line B 15 may include a plurality of first type fourth data fan-out lines and a plurality of second type fourth data fan-out lines, the first type fourth data fan-out lines and the second type fourth data fan-out lines may be arranged at intervals, and an orthographic projection of the first type fourth data fan-out lines on the base substrate may not be overlapped with an orthographic projection of the second type fourth data fan-out lines on the base substrate. For example, the first type fourth data fan-out lines may be located in the first source-drain metal layer, and the second type fourth data fan-out lines may be located in the second source-drain metal layer to reduce a resistivity of the fourth data fan-out lines, thereby reducing load of data lines. However, this embodiment is not limited thereto.

In some examples, data lead-out lines of the first bezel area may include a first data connection line 50, a first data fan-out line 51, a second data fan-out line 52, a data bending line 53, a third data fan-out line 54, and a fourth data fan-out line 55 electrically connected in sequence.

FIG. 49 is a partial schematic diagram of a second bezel area according to at least one embodiment of the present disclosure. In some examples, as shown in FIG. 49, the display substrate may include a plurality of first signal lines located within the second bezel area B2 and extending in the first direction X. For example, the plurality of first signal lines may include a third bezel initial line 155, a fourth bezel initial line 156, a first bezel trace 601, a second bezel trace 602, a third bezel trace 603, a fourth bezel trace 604, and a fifth bezel trace 605. At least one first signal line may be connected with a second compensation unit 42, and the second compensation unit 42 may be configured to compensate at least one of resistance and capacitance of the first signal line connected therewith.

In some examples, as shown in FIG. 49, the third bezel initial line 155 may be electrically connected with a first initial signal line INIT1 within the display area AA and configured to transmit a first initial signal. The fourth bezel initial line 156 may be electrically connected with a second initial signal line INIT2 within the display area AA and configured to transmit a second initial signal. The first bezel trace 601 may be electrically connected with a first reset control line RST1 within the display area AA and configured to transmit a first reset control signal. The second bezel trace 602 may be electrically connected with a first scan line GL1 within the display area AA and configured to transmit a first scan signal. The third bezel trace 603 may be electrically connected with a scan connection line 121 within the display area AA and configured to provide a signal to a bottom gate of an eighth transistor of a pixel circuit. The fourth bezel trace 604 may be electrically connected with a second scan line GL2 within the display area AA and configured to transmit a second scan signal. The fifth bezel trace 605 may be electrically connected with a light emitting control line EML within the display area AA and configured to transmit a light emitting control signal. The first bezel trace 601, the second bezel trace 602, the fourth bezel trace 604, and the fifth bezel trace 605 may also be electrically connected with a corresponding gate drive circuit. For example, a gate drive circuit within the second bezel area B2 may include a first scan drive circuit, a second scan drive circuit, and a light emitting control drive circuit. The first bezel trace 601 and the second bezel trace 602 may be electrically connected with an output terminal of the first scan drive circuit and configured to receive a first scan signal. The fourth bezel trace 604 may be electrically connected with an output terminal of the second scan drive circuit and configured to receive a second scan signal. The fifth bezel trace 605 may be electrically connected with an output terminal of the light emitting control drive circuit and configured to receive a light emitting control signal.

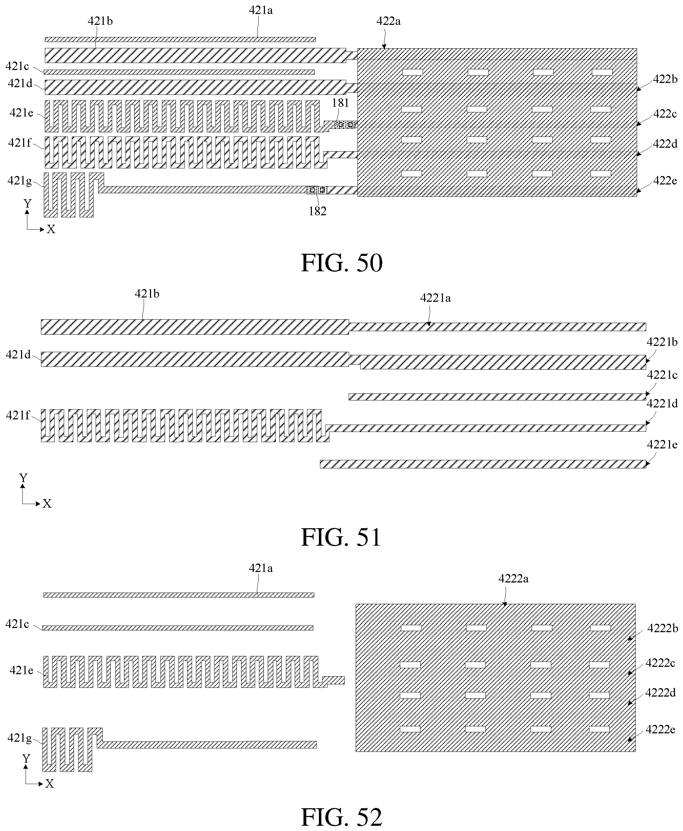

FIG. 50 is an exemplary schematic diagram of a second compensation unit according to at least one embodiment of the present disclosure. FIG. 51 is a schematic diagram of a first gate metal layer in FIG. 50. FIG. 52 is a schematic diagram of a second gate metal layer in FIG. 50. In some examples, as shown in FIG. 49 to FIG. 52, a second compensation unit 42 electrically connected with the third bezel initial line 155 may include a second compensation resistor 421a. The second compensation resistor 421a may include a resistor trace located in the second gate metal layer and in a linear shape. The second compensation resistor 421a may extend to be electrically connected with the first initial signal line INIT1 of the display area or may be electrically connected with the first initial signal line INIT1 through a connection electrode.

In some examples, as shown in FIG. 49 to FIG. 52, one end of the first bezel trace 601 may be electrically connected with an output terminal of a gate drive circuit (e.g., a first scan drive circuit), and the other end of the first bezel trace 601 may be electrically connected with the second compensation unit 42. The second compensation unit 42 electrically connected with the first bezel trace 601 may include a second compensation resistor 421b and a second compensation capacitor 422a. The second compensation resistor 421b may include a resistor trace located in the first gate metal layer and in a linear shape. The second compensation capacitor 422a may include a first electrode 4221a and a second electrode 4222a. The first electrode 4221a may be located in the first gate metal layer and may be of an integral structure with the second compensation resistor 421b, and the second electrode 4222a may be located in the second gate metal layer. The first electrode 4221a of the second compensation capacitor 422a may extend to be electrically connected with the first reset control line RST1 of the display area or may be electrically connected with the first reset control line RST1 through a connection electrode.

In some examples, as shown in FIG. 49 to FIG. 52, the second compensation unit 42 electrically connected with the fourth bezel initial line 156 may include a second compensation resistor 421c. The second compensation resistor 421c may include a resistor trace located in the second gate metal layer and in a linear shape. The second compensation resistor 421c may extend to be electrically connected with the second initial signal line INIT2 of the display area or may be electrically connected with the second initial signal line INIT2 through a connection electrode.

In some examples, as shown in FIG. 49 to FIG. 52, one end of the second bezel trace 602 may be electrically connected with an output terminal of a gate drive circuit (e.g., a first scan drive circuit), and the other end of the second bezel trace 602 may be electrically connected with the second compensation unit 42. The second compensation unit 42 electrically connected with the second bezel trace 602 may include a second compensation resistor 421d and a second compensation capacitor 422b. The second compensation resistor 421d may include a resistor trace located in the first gate metal layer and in a linear shape. The second compensation capacitor 422b may include a first electrode 4221b and a second electrode 4222b. The first electrode 4221b may be located in the first gate metal layer and may be of an integral structure with the second compensation resistor 421d, and the second electrode 4222b may be located in the second gate metal layer. The first electrode 4221b of the second compensation capacitor 422b may extend to be electrically connected with the first scan line GL1 of the display area or may be electrically connected with the first scan line GL1 through a connection electrode.

In some examples, as shown in FIG. 49 to FIG. 52, the second compensation unit 42 electrically connected with the third bezel trace 603 may include a second compensation resistor 421e and a second compensation capacitor 422c. The second compensation resistor 421e may include a resistor trace located in the second gate metal layer and in a serpentine shape. The second compensation capacitor 422b may include a first electrode 4221c and a second electrode 4222c, the first electrode 4221c may be located in the first gate metal layer and electrically connected with the second compensation resistor 421e through a twenty-first connection electrode 181, and the second electrode 4222c may be located in the second gate metal layer. The first electrode 4221c of the second compensation capacitor 422c may extend to be electrically connected with the scan connection line 121 of the display area or may be electrically connected with the scan connection line 121 through a connection electrode.

In some examples, as shown in FIG. 49 to FIG. 52, one end of the fourth bezel trace 604 may be electrically connected with an output terminal of a gate drive circuit (e.g., a second scan drive circuit), and the other end of the fourth bezel trace 604 may be electrically connected with the second compensation unit 42. The second compensation unit 42 electrically connected with the second bezel trace 604 may include a second compensation resistor 421f and a second compensation capacitor 422d. The second compensation resistor 421f may include a resistor trace located in the first gate metal layer and in a serpentine shape. The second compensation capacitor 422d may include a first electrode 4221d and a second electrode 4222d, the first electrode 4221d may be located in the first gate metal layer and may be of an integral structure with the second compensation resistor 421f, and the second electrode 4222d may be located in the second gate metal layer. The first electrode 4221d of the second compensation capacitor 422d may extend to be electrically connected with the second scan line GL2 of the display area or may be electrically connected with the second scan line GL2 through a connection electrode.

In some examples, as shown in FIG. 49 to FIG. 52, one end of the fifth bezel trace 605 may be electrically connected with an output terminal of a gate drive circuit (e.g., a light emitting control drive circuit), and the other end of the fifth bezel trace 605 may be electrically connected with the second compensation unit 42. The second compensation unit 42 electrically connected with the fifth bezel trace 605 may include a second compensation resistor 421g and a second compensation capacitor 422e. The second compensation resistor 421g may include a resistor trace located in the second gate metal layer and in a serpentine shape. The second compensation capacitor 422e may include a first electrode 4221e and a second electrode 4222e, the first electrode 4221e may be located in the first gate metal layer and electrically connected with the second compensation resistor 421g through a twenty-second connection electrode 182, and the second electrode 4222e may be located in the second gate metal layer. The first electrode 4221e of the second compensation capacitor 422e may extend to be electrically connected with the light emitting control line EML of the display area or may be electrically connected with the light emitting control line EML through a connection electrode.

Among them, the twenty-first connection electrode 181 and the twenty-second connection electrode 182 may be located in the first source-drain metal layer. Second electrodes of second compensation capacitors 422a, 422b, 422c, 422d, and 422e may be of an integral structure. A second electrode of a second compensation capacitor may be electrically connected with a ground connection line (the ground connection line 61 as shown in FIG. 22) so as to be electrically connected with a ground terminal of a second signal access region (the second signal access region B17 as shown in FIG. 22). A double-electrode plate structure may be used for the second compensation capacitor of this example. However, this embodiment is not limited thereto.

In some examples, a second compensation unit corresponding to an electrical connection may be provided according to a resistance and a capacitance sof a first signal line. For example, a first bezel initial trace and a second bezel initial trace may only be connected with a second compensation resistor for resistance compensation. Resistance required to be compensated by the first bezel trace 601 and the second bezel trace 602 may be relatively small, and resistance required to be compensated by the third bezel trace 603, the fourth bezel trace 604, and the fifth bezel trace 605 may be relatively large.

In the display substrate according to this example, voltage drop (IR Drop) of a signal transmitted by the first signal line in the display area may be reduced by providing the second compensation unit, thus ensuring display uniformity. Moreover, signal verification may be performed on a large-sized display substrate on a small-sized display substrate.

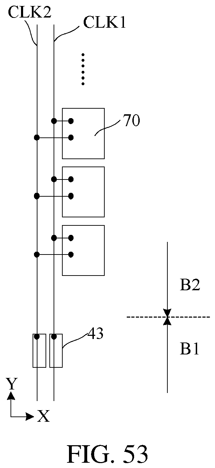

FIG. 53 is a schematic diagram of a connection of a third compensation unit according to at least one embodiment of the present disclosure. In some examples, as shown in FIG. 53, the second bezel area B2 may be provided with a gate drive circuit and a clock signal line (which for example, may include a first clock signal line CLK1 and a second clock signal line CLK2). One gate drive circuit may include a plurality of cascaded drive sub-circuits 70. The first clock signal line CLK1 and the second clock signal line CLK2 may provide a first clock signal and a second clock signal for the plurality of drive sub-circuits 70. The first clock signal line CLK1 may be electrically connected with one third compensation unit 43 and the second clock signal line CLK2 may be electrically connected with one third compensation unit 43. A third compensation unit 43 may be located in the first bezel area B1, for example, may be located in a lower left corner region and a lower right corner region of the first bezel area B1. The third compensation unit 43 may include a third compensation resistor and a third compensation capacitor. The third compensation unit 43 may be configured to provide at least one of resistance and capacitance compensation to a clock signal line electrically connected with the third compensation unit 43. Structures and a connection mode of the third compensation resistor and the third compensation capacitor may be referred to structures and a connection mode of the first compensation resistor and the first compensation capacitor of the foregoing embodiment, or may be referred to structures and a connection mode of the second compensation resistor and the second compensation capacitor of the foregoing embodiment, which will not be repeated here.

The structure of the display substrate will be described below through an example of a manufacturing process of the display substrate. A "patterning process" mentioned in the embodiments of the present disclosure includes a treatment such as photoresist coating, mask exposure, development, etching, and photoresist stripping for a metal material, an inorganic material, or a transparent conductive material, and includes a treatment such as organic material coating, mask exposure, and development for an organic material. Deposition may be any one or more of sputtering, evaporation and chemical vapor deposition, the coating may be any one or more of spray coating, spin coating and inkjet printing, and the etching may be any one or more of dry etching and wet etching, the present disclosure is not limited thereto. A "thin film" refers to a layer of thin film made of a material on a base substrate by using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are disposed in a same layer" mentioned in the embodiments of the present disclosure means that A and B are formed simultaneously through a same patterning process, or surfaces of A and B close to a base substrate have basically a same distance from the base substrate, or the surfaces of A and B close to the base substrate are in direct contact with a same film layer. A "thickness" of a film layer is a dimension of the film layer in a direction perpendicular to the display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

In some exemplary implementations, a manufacturing process of the display substrate may include following operations.

(1) A base substrate is provided. In some examples, the base substrate 100 may be a rigid substrate such as a glass substrate; or it may be a flexible substrate. This embodiment is not limited thereto.

(2) A light shielding layer is formed. In some examples, a first conductive thin film is deposited on the base substrate 100, and the first conductive thin film is patterned through a patterning process to form a light shielding layer. As shown in FIG. 6 and FIG. 27, the light shielding layer may include a light shielding trace 111 located in the display area and a bezel light shielding trace 112 located in the first bezel area.

(3) A first semiconductor layer is formed. In some examples, a first insulation thin film and a first semiconductor thin film are deposited sequentially on the base substrate 100 on which the aforementioned structure is formed, and the first semiconductor thin film is patterned through a patterning process to form a first insulation layer 101 and a first semiconductor layer disposed on the first insulation layer 101. As shown in FIG. 7 and FIG. 28, the first semiconductor layer may include active layers of first type transistors of a plurality of pixel circuits located in the display area, and active layers of a plurality of release transistors of a first anti-static circuit located in the first bezel area. In some examples, a material of the first semiconductor layer 12 may be polysilicon.

(4) A first gate metal layer is formed. In some examples, a second insulation thin film and a second conductive thin film are sequentially deposited on the base substrate 100 where the aforementioned structures are formed, and the second conductive thin film is patterned through a patterning process to form a second insulation layer 102 and a first gate metal layer disposed on the second insulation layer 102. As shown in FIG. 8, FIG. 29, FIG. 38, FIG. 47, and FIG. 51, the first gate metal layer may include: gates of first type transistors of a plurality of pixel circuits located in the display area, a first electrode of a storage capacitor, and a light emitting control line EML; a third power supply line VGH, a fourth power supply line VGL, gates of a plurality of release transistors of a first anti-static circuit, resistor traces of a plurality of first compensation resistors, first electrode plates of a plurality of first compensation capacitors, and a plurality of first type second data fan-out lines located in the first bezel area; a resistor trace of a second compensation resistor located in the second bezel area, and a first electrode of a second compensation capacitor.

(5) A second gate metal layer is formed. In some examples, a third insulation thin film and a third conductive thin film are sequentially deposited on the base substrate 100 where the aforementioned structures are formed, and the third conductive thin film is patterned through a patterning process to form a third insulation layer 103 and a second gate metal layer disposed on the third insulation layer 103. As shown in FIG. 9, FIG. 30, FIG. 39, FIG. 47, and FIG. 52, the second gate metal layer may include: a second electrode of a storage capacitor of a pixel circuit located in the display area, a scan connection line 121, a first initial signal line INIT1, a second initial signal line INIT2; a resistor trace of a first compensation resistor located in the first bezel area, a second electrode plate of a first compensation capacitor; a resistor trace of a second compensation resistor located in the second bezel area, and a second electrode of a second compensation capacitor.

(6) A second semiconductor layer is formed. In some examples, a fourth insulation thin film and a second semiconductor thin film are sequentially deposited on the base substrate 100 on which the aforementioned structures are formed, and the second semiconductor thin film is patterned through a patterning process to form a fourth insulation layer 104 and a second semiconductor layer disposed on the fourth insulation layer 104. As shown in FIG. 10, the second semiconductor layer may include an active layer of a second type transistor of a pixel circuit located in the display area. In some examples, a material of the second semiconductor layer may be IGZO.

(7) A third gate metal layer is formed. In some examples, a fifth insulation thin film and a fourth conductive thin film are sequentially deposited on the base substrate 100 where the aforementioned structures are formed, and the fourth conductive thin film is patterned through a patterning process to form a fifth insulation layer 105 and a third gate metal layer disposed on the fifth insulation layer 105. In some examples, as shown in FIG. 11 and FIG. 40, the third gate metal layer may include a gate of a second type transistor of a pixel circuit located in the display area; a third electrode plate of a second compensation capacitor located in the first bezel area.

(8) A sixth insulation layer is formed. In some examples, a sixth insulation thin film is deposited on the base substrate 100 where the aforementioned structures are formed, the sixth insulation thin film is patterned through a patterning process to form a sixth insulation layer 106, and a portion of an insulation layer (e.g., the first insulation layer to the sixth insulation layer) of the bending region of the first bezel area is etched through a first-time mask (Etch Bending A MASK, abbreviated as EBA MASK).

(9) A first source-drain metal layer is formed. In some examples, a fifth conductive thin film is deposited on the base substrate 100 where the aforementioned structures are formed, and the fifth conductive thin film is patterned through a patterning process to form a first source-drain metal layer. In some examples, as shown in FIG. 13, FIG. 32, and FIG. 44, the first source-drain metal layer may include at least a plurality of connection electrodes located in the display area, a first power supply connection line 131, a first scan line GL1; and a plurality of first data connection lines 50 located in the first bezel area and a plurality of connection electrodes.

(10) A second source-drain metal layer is formed. In some examples, a seventh insulation thin film is deposited on the base substrate 100 where the aforementioned structures are formed, the seventh insulation thin film is patterned through a patterning process to form a seventh insulation layer 107, and a portion of an insulation layer (e.g., the seventh insulation layer) of a bending region of the first bezel area is etched through a second-time mask (Etch Bending B MASK, abbreviated as EBB MASK). Subsequently, an eighth insulation thin film is coated and patterned through a patterning process to form an eighth insulation layer 108. Subsequently, a sixth conductive thin film is deposited, and the sixth conductive thin film is patterned through a patterning process to form a second source-drain metal layer. In some examples, as shown in FIG. 15 and FIG. 34, the second source-drain metal layer may include at least a plurality of data lines located in the display area, a second power supply connection line, a second anode connection electrode; and a first bezel initial line 153 and a second bezel initial line 154 that are located in the first bezel area.

(11) A third source-drain metal layer is formed. In some examples, a ninth insulation thin film is coated on the base substrate on which the aforementioned structures are formed, and the ninth insulation thin film is patterned through a patterning process to form a ninth insulation layer 109. Subsequently, a seventh conductive thin film is deposited, and the seventh conductive thin film is patterned through a patterning process to form a third source-drain metal layer. In some examples, as shown in FIG. 18 and FIG. 26, the third source-drain metal layer may include at least a first initial connection line 151, a second initial connection line 152, a third power supply connection line 133, and a fourth power supply connection line 134 located in the display area; and a fifth power supply connection line 135 located in the first bezel area.

(12) A tenth insulation layer is formed. In some examples, a tenth insulation thin film is coated on the base substrate on which the aforementioned structures are formed, and the tenth insulation thin film is patterned through a patterning process to form a tenth insulation layer 110.

(13) A light emitting structure layer and an encapsulation structure layer are formed.

In some examples, an anode thin film is deposited on the base substrate 100 where the aforementioned structures are formed, and the anode thin film is patterned through a patterning process to form an anode layer. A pixel definition thin film is coated on the base substrate 100 on which the aforementioned patterns are formed, and a pixel definition layer is formed through mask, exposure, and development processes. The pixel definition layer 34 of the display area is provided with a plurality of pixel openings. An organic emitting layer is formed in a pixel opening, and the organic emitting layer is connected with an anode. Subsequently, a cathode thin film is deposited, the cathode thin film is patterned through a patterning process to form a cathode layer, and the cathode layer may be electrically connected with the organic emitting layer. Subsequently, the encapsulation structure layer is formed on the cathode layer, and the encapsulation structure layer may include a stacked structure of an inorganic material/an organic material/an inorganic material.

In an exemplary implementation mode, the light shielding layer, the first gate metal layer, the second gate metal layer, the third gate metal layer, the first source-drain metal layer, the second source-drain metal layer, and the third source-drain metal layer may be made of a metal material, such as any one or more of Argentum (Ag), Copper (Cu), Aluminum (Al) and Molybdenum (Mo), or an alloy material of the above metals, such as an Aluminum Neodymium (AlNd) alloy or a Molybdenum Niobium (MoNb) alloy, and may be of a single-layer structure or a multi-layer composite structure, such as Mo/Cu/Mo. The first insulation layer 101 to the seventh insulation layer 107 may be made of any one or more of Silicon Oxide (SiOx), Silicon Nitride (SiNx), and Silicon Oxynitride (SiON), and may be a single layer, a multi-layer, or a composite layer. The eighth insulation layer 108 to the tenth insulation layer 110 may also be referred to as planarization layers, and may be made of an organic material such as polyimide, acrylic, or polyethylene terephthalate. The pixel definition layer may be made of an organic material, such as polyimide, acrylic, or polyethylene terephthalate. The anode layer may be made of a reflective material such as a metal and the cathode layer may be made of a transparent conductive material. However, this embodiment is not limited thereto.

A structure and a manufacturing process of the display substrate of this embodiment are merely illustrative. In some exemplary implementation, a corresponding structure may be changed and a patterning process may be added or removed according to actual needs. The manufacturing process of the exemplary embodiment may be implemented using an existing mature manufacturing device, and may be compatible well with an existing manufacturing process, simple in process implementation, easy to implement, high in a production efficiency, low in a production cost, and high in yield.

In some examples, resistance and capacitance of a data line are compensated by providing a first compensation unit, resistance and capacitance of a first signal line are compensated by providing a second compensation unit, and resistance and capacitance of a clock signal line are compensated by providing a third compensation unit. Performance of a large-sized display substrate may be verified on a small-sized display substrate, thus verification costs may be saved. Furthermore, by performing resistance and capacitance compensation on the data line, the first signal line, and the clock signal line, IR Drop of a signal of the display area may be reduced, thereby ensuring display uniformity. In addition, the first compensation unit, the second compensation unit, and the third compensation unit of this example may determine arrangement space according to a maximum compensation amount required by a corresponding signal line to achieve space optimization.

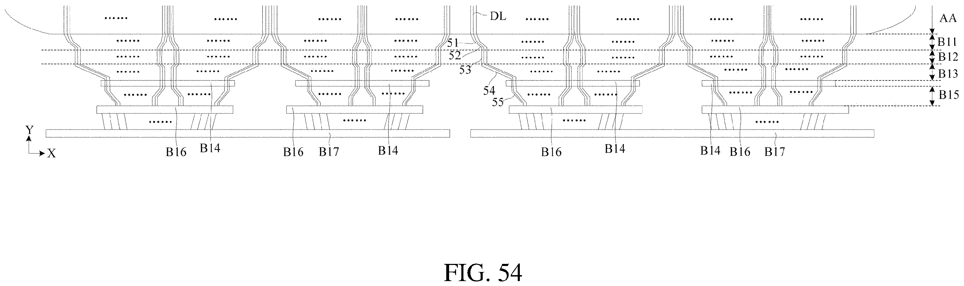

FIG. 54 is another schematic diagram of a first bezel area according to at least one embodiment of the present disclosure. In some examples, as shown in FIG. 54, the first bezel area may include a first fan-out region B11, a bending region B12, a second fan-out region B13, four first circuit regions B14, a third fan-out region B15, four first signal access regions B16, and two second signal access regions B17 arranged in sequence along a side away from the display area AA. The four first circuit regions B14 are sequentially arranged along the first direction X, the four first signal access regions B16 may be sequentially arranged along the first direction X, and the two second signal access regions B 17 may be sequentially arranged along the first direction X. One first signal access region B17 may correspond to two first signal access regions B16 and two first circuit regions B 14. A trace within the first bezel area may be as shown in the foregoing embodiments, and the first compensation unit may be located in the first fan-out region or the second fan-out region. This embodiment is not limited thereto. Rest of the structure of the display substrate according to this embodiment may be referred to descriptions of the aforementioned embodiments, and will not be repeated here.

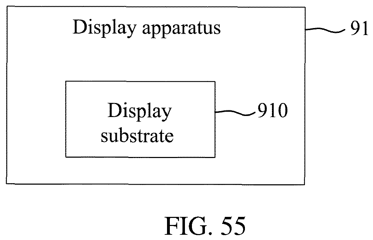

FIG. 55 is a schematic diagram of a display device according to at least one embodiment of the present disclosure. In some examples, as shown in FIG. 55, an embodiment provides a display device 91, including a display substrate 910. The display substrate 910 is the display substrate provided in the above-mentioned embodiments. Herein, the display substrate 910 may be an OLED display substrate. The display device 91 may be any product or component with a display function, such as an OLED display device, a mobile phone, a tablet computer, a television, a display, a notebook computer, a digital photo bezel, and a navigator. However, this embodiment is not limited thereto.

The drawings of the present disclosure only involve structures involved in the present disclosure, and other structures may refer to conventional designs. The embodiments of the present disclosure, i.e., features in the embodiments, may be combined with each other to obtain new embodiments if there is no conflict. Those of ordinary skills in the art should understand that modifications or equivalent replacements may be made to the technical solutions of the present disclosure without departing from the spirit and scope of the technical solutions of the present disclosure, which shall all fall within the scope of the claims of the present application.

## Claims

1. A display substrate, comprising:

    a base substrate, comprising a display area and a first bezel area located on a side of the display area;
    a plurality of data lines located in the display area;
    a plurality of sub-pixels located in the display area and electrically connected with the plurality of data lines;
    a plurality of data lead-out lines, which are located in the first bezel area and are electrically connected with the plurality of data lines in the display area; and
    at least one first compensation unit located in the first bezel area;
    at least one data lead-out line of the plurality of data lead-out lines is electrically connected with the at least one first compensation unit, and the at least one first compensation unit is configured to compensate at least one of resistance and capacitance of a data line electrically connected with the at least one data lead-out line.

2. The display substrate according to claim 1, wherein each first compensation unit comprises at least one of: at least one first compensation resistor and at least one first compensation capacitor;
    the at least one first compensation resistor is configured to compensate the resistance of the data line electrically connected with the at least one data lead-out line, and the at least one first compensation capacitor is configured to compensate the capacitance of the data line electrically connected with the at least one data lead-out line.

3. The display substrate according to claim 2, wherein the first compensation unit comprises:
    at least one first compensation resistor, and the at least one first compensation resistor is electrically connected in series with the at least one data lead-out line.

4. The display substrate according to claim 2 or 3, wherein the at least one first compensation resistor comprises a resistor trace located in a first gate metal layer or a second gate metal layer, and the first gate metal layer and the second gate metal layer are located in different layers.

5. The display substrate according to claim 4, wherein an orthographic projection of the resistor trace of the first compensation resistor on the base substrate is a serpentine trace.

6. The display substrate according to any one of claims 2 to 5, wherein the first compensation unit further comprises: at least one first compensation capacitor, the at least one first compensation capacitor comprises a first electrode and a second electrode, the first electrode of the at least one first compensation capacitor is electrically connected with the at least one first compensation resistor, and the second electrode of the at least one first compensation capacitor is electrically connected with a ground terminal.

7. The display substrate according to claim 6, wherein the at least one first compensation capacitor comprises: a first electrode plate, a second electrode plate, and a third electrode plate arranged in sequence along a direction away from the base substrate, orthographic projections of the first electrode plate, the second electrode plate, and the third electrode plate on the base substrate are overlapped; the first electrode plate and the third electrode plate are electrically connected with each other to form the first electrode, and the second electrode plate serves as the second electrode.

8. The display substrate according to claim 7, wherein the second electrode plate of the at least one first compensation capacitor is of an integral structure.

9. The display substrate according to claim 7 or 8, wherein the first electrode plate is located in a first gate metal layer, the second electrode plate is located in a second gate metal layer, and the third electrode plate is located in a third gate metal layer; the first gate metal layer, the second gate metal layer, and the third gate metal layer are located in different layers.

10. The display substrate according to any one of claims 1 to 9, wherein the first bezel area comprises: a first fan-out region located on one side of the display area, and the first fan-out region is provided with at least one dam spacer;

at least one data lead-out line of the plurality of data lead-out lines comprises: a first data fan-out line and a second data fan-out line which are located in the first fan-out region and electrically connected with each other, wherein the second data fan-out line is located on a side of the first data fan-out line away from the display area; the second data fan-out line is located on a side of the first data fan-out line close to the base substrate; a connection position of the first data fan-out line and the second data fan-out line is located on a side of the dam spacer close to the display area, and an orthographic projection of the connection position on the base substrate is not overlapped with an orthographic projection of the dam spacer on the base substrate.

11. The display substrate according to claim 10, wherein a resistivity of a material of the first data fan-out line is less than a resistivity of a material of the second data fan-out line.

12. The display substrate according to claim 10 or 11, wherein the first fan-out region comprises: a plurality of first data fan-out lines and a plurality of second data fan-out lines;

the plurality of first data fan-out lines comprise a plurality of first type first data fan-out lines and a plurality of second type first data fan-out lines, wherein the first type first data fan-out lines and the second type first data fan-out lines are arranged at intervals, a first type first data fan-out line is located on a side of a second type first data fan-out line close to the base substrate, and an orthographic projection of the first type first data fan-out line on the base substrate is not overlapped with an orthographic projection of the second type first data fan-out line on the base substrate; and
the plurality of second data fan-out lines comprise a plurality of first type second data fan-out lines and a plurality of second type second data fan-out lines, the first type second data fan-out lines and the second type second data fan-out lines are arranged at intervals, a first type second data fan-out line is located on a side of a second type second data fan-out line close to the base substrate, and an orthographic projection of the first type second data fan-out line on the base substrate is not overlapped with an orthographic projection of the second type second data fan-out line on the base substrate.

13. The display substrate according to claim 12, wherein the first type first data fan-out line is electrically connected with the first type second data fan-out line, and the second type first data fan-out line and the second type second data fan-out line are electrically connected.

14. The display substrate of claim 12 or 13, wherein the first type first data fan-out line is located in a first source-drain metal layer and the second type first data fan-out line is located in a second source-drain metal layer; the first type second data fan-out line is located in a first gate metal layer, and the second type second data fan-out line is located in a second gate metal layer; and
the first gate metal layer, the second gate metal layer, the first source-drain metal layer, and the second source-drain metal layer are located in different layers.

15. The display substrate according to any one of claims 10 to 14, wherein the first compensation unit is electrically connected with the first data fan-out line, and the first compensation unit is located in the first fan-out region and on a side of the first data fan-out line close to the display area.

16. The display substrate according to any one of claims 10 to 15, wherein the first bezel area further comprises: a bending region and a second fan-out region arranged in sequence along a direction of the first fan-out region away from the display area; and
the at least one data lead-out line comprises: a data bending line located in the bending region and a third data fan-out line located in the second fan-out region; the data bending line is electrically connected with the second data fan-out line of the first fan-out region and a third data fan-out line of the second fan-out region.

17. The display substrate according to claim 16, wherein the first data fan-out line and the third data fan-out line that are electrically connected with the second data fan-out line are disposed in a same layer.

18. The display substrate according to any one of claims 1 to 17, wherein the base substrate further comprises: a second bezel area located on remaining sides of the display area; the second bezel area is provided with at least one second compensation unit and at least one first signal line; the at least one first signal line is electrically connected with the at least one second compensation unit, and the at least one second compensation unit is configured to compensate at least one of resistance and capacitance of the at least one first signal line.

19. The display substrate according to claim 18, wherein each second compensation unit comprises at least one second compensation capacitor, a first electrode of the at least one second compensation capacitor is electrically connected with the at least one first signal line, and a second electrode of the at least one second compensation capacitor is electrically connected with a ground terminal.

20. The display substrate according to any one of claims 1 to 19, wherein the base substrate further comprises a second bezel area located on remaining sides of the display area;

the second bezel area is provided with a gate drive circuit and a clock signal line electrically connected with the gate drive circuit;
the first bezel area is further provided with a third compensation unit, the clock signal line is electrically connected with the third compensation unit, and the third compensation unit is configured to compensate at least one of resistance and capacitance of the clock signal line.

21. A display device, comprising the display substrate according to any one of claims 1 to 20.

Px

AA

DL

B2

DA2
DA1

B11
B12
B13
B14
B15

B1

Y

X

B17    B16

## FIG. 1

PL1

Cst

T5    EML

N2    T4    DL

N1    T3    GL1

GL2    T8

N5    T2    N3

GL1

RST1    T1    T6    EML

N4    T7    INIT2

INIT1    EL

RST2

PL2

## FIG. 2

FIG. 3

FIG. 4

GL2 GL1 132 155 133 201a 202a 131 204 203 141 143a 30

20

201 201
19
18
17
16
15
14
13
12
11

10

201a
110
109
142
108
107
106
105
104
103
102
101

100 121 T41 T31/ Cst-2 T30 111 T61 T60
T80 Cst-1

## FIG. 5

Y
X

## FIG. 6

FIG. 7

FIG. 8

INIT1

INIT2

121

Cst-2

Y

X

FIG. 9

T80

Y

X

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

EP 4 421 792 A1

FIG. 23

FIG. 24

FIG. 25

FIG. 26

111

112

Y
X

FIG. 27

111

112

Y
X

ST40
ST30
ST20
ST10

Y
X

FIG. 28

FIG. 29

111

112

Y

X

411b

FIG. 30

FIG. 31

111

112

50

175

174

173

172

171

Y

X

FIG. 32

V65

V66

Y

X

FIG. 33

DLa  DLb

153

154

176

Y

X

FIG. 34

FIG. 35

411b    411a

4112

4111

Y

X

FIG. 36

411b    411a

R1

177    178

C1

Y

X

FIG. 37

FIG. 38

FIG. 39

FIG. 40

FIG. 41

FIG. 42

FIG. 43

414b   414a

V81   V82
179
51a

Y
X

FIG. 44

FIG. 45

DA1 — DA13
— DA12
51b — DA11

DA2 — DA23
— DA22
— DA21

180  52b  100  101  102  103  104  105  106  107  108  109

## FIG. 46

52b  52a

Y
X

## FIG. 47

FIG. 48

FIG. 49

FIG. 50

FIG. 51

FIG. 52

FIG. 53

FIG. 54

EP 4 421 792 A1

FIG. 55

## INTERNATIONAL SEARCH REPORT

| International application No. |
|---|
| **PCT/CN2022/113060** |

### A. CLASSIFICATION OF SUBJECT MATTER

G09G3/3233(2016.01)i

According to International Patent Classification (IPC) or to both national classification and IPC

### B. FIELDS SEARCHED

Minimum documentation searched (classification system followed by classification symbols)

IPC: G09G; H01L

Documentation searched other than minimum documentation to the extent that such documents are included in the fields searched

Electronic data base consulted during the international search (name of data base and, where practicable, search terms used)

CNABS, CNTXT: 边框区, 扇出区, 非显示区, 数据线, 信号线, 补偿, 电容, 电阻, 间隔, 交替, 连接线, 引出线, 引线, 走线, 同层; VEN, USTXT, EPTXT: frame area, fan-out area, non-display area, signal line, data line, compensation, capacitance, resistance, interval, alternation, connect line, lead line, same layer

### C. DOCUMENTS CONSIDERED TO BE RELEVANT

| Category* | Citation of document, with indication, where appropriate, of the relevant passages | Relevant to claim No. |
|---|---|---|
| X | CN 108010942 A (WUHAN TIANMA MICRO-ELECTRONICS CO., LTD.) 08 May 2018 (2018-05-08) <br> description, paragraphs 32-71, and figures 1-13 | 1-9, 18-21 |
| Y | CN 108010942 A (WUHAN TIANMA MICRO-ELECTRONICS CO., LTD.) 08 May 2018 (2018-05-08) <br> description, paragraphs 32-71, and figures 1-13 | 10-17 |
| Y | CN 202975551 U (BEIJING BOE OPTOELECTRONICS TECHNOLOGY CO., LTD.) 05 June 2013 (2013-06-05) <br> description, paragraphs 36-71, and figures 1-10 | 10-17 |
| Y | CN 1743927 A (AU OPTRONICS CORPORATION) 08 March 2006 (2006-03-08) <br> description, page 6, paragraph 1, and figure 12 | 10-17 |
| E | WO 2022226994 A1 (BOE TECHNOLOGY GROUP CO., LTD. et al.) 03 November 2022 (2022-11-03) <br> description, page 4, line 30 to page 26, line 23, and figures 1-19 | 1-4, 21 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **23 April 2023** | **16 May 2023** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2022/113060** |

**C. DOCUMENTS CONSIDERED TO BE RELEVANT**

| Category* | Citation of document, with indication, where appropriate, of the relevant passages | Relevant to claim No. |
| --- | --- | --- |
| E | CN 115188792 A (BOE TECHNOLOGY GROUP CO., LTD. et al.) 14 October 2022 (2022-10-14) description, paragraphs 64-150, and figures 1-20 | 1-3, 21 |
| A | JP 2007140152 A (HITACHI LTD.) 07 June 2007 (2007-06-07) entire document | 1-21 |

Form PCT/ISA/210 (second sheet) (July 2022)

INTERNATIONAL SEARCH REPORT
Information on patent family members

International application No.

**PCT/CN2022/113060**

| Patent document cited in search report | | | Publication date (day/month/year) | Patent family member(s) | | | Publication date (day/month/year) |
|---|---|---|---|---|---|---|---|
| CN | 108010942 | A | 08 May 2018 | CN | 108010942 | B | 30 June 2020 |
| CN | 202975551 | U | 05 June 2013 | None | | | |
| CN | 1743927 | A | 08 March 2006 | CN | 100388101 | C | 14 May 2008 |
| WO | 2022226994 | A1 | 03 November 2022 | CN | 115552625 | A | 30 December 2022 |
| CN | 115188792 | A | 14 October 2022 | None | | | |
| JP | 2007140152 | A | 07 June 2007 | None | | | |

Form PCT/ISA/210 (patent family annex) (July 2022)